# EUROPÄISCHE PATENTSCHRIFT

(11) **EP 3 345 301 B1**
(45) Veröffentlichungstag und Bekanntmachung des Hinweises auf die Patenterteilung: **28.08.2019**
(21) Anmeldenummer: 16760052.7
(22) Anmeldetag: 31.08.2016
(51) Int. Cl.: H02S 50/00

(54) **SICHERE PHOTOVOLTAIK-ANLAGE**
SAFE PHOTOVOLTAIC SYSTEM
SYSTÈME PHOTOVOLTAÏQUE SÛR

(30) Priorität: 03.09.2015 DE 102015114755
(43) Veröffentlichungstag der Anmeldung: 11.07.2018
(73) Patentinhaber: Phoenix Contact GmbH & Co. KG, 32825 Blomberg (DE)
(72) Erfinder: HÖFT, Wolfgang, 32683 Barntrup (DE)
(74) Vertreter: Blumbach · Zinngrebe Patentanwälte PartG mbB
(86) Internationale Anmeldenummer: PCT/EP2016/070504
(87) Internationale Veröffentlichungsnummer: WO 2017/037110

(56) Entgegenhaltungen:
- DE-A1-102013 101 314
- US-A1- 2008 106 250

## Beschreibung

### Gebiet der Erfindung

Die Erfindung betrifft eine Photovoltaik-Anlage mit zumindest einem Strang aus seriell zusammengeschalteten Solarmodulen und einem Wechselrichter, eine in zumindest eine Strangzuleitung zwischen den Strang und den Wechselrichter schaltbare Prüfschaltung und ein Prüfverfahren.

### Hintergrund der Erfindung

Bisher sind Solarmodule häufig ohne besondere Sicherheitsvorkehrungen ausgestattet. Die bei jedem Solarmodul vorhandene Solaranschlussdose (auch Anschlussbox oder junction box genannt) dient im Wesentlichen zum Anschließen der Leiterbänder (auch ribbons genannt) des Solarmoduls sowie zur Aufnahme der Bypass-Dioden. Solch einfache Solarmodule liefern Spannung an den Ausgangskontakten der Solaranschlussdose sobald sie beleuchtet werden.

Typischerweise werden die Solarmodule zu Strängen seriell zusammengeschaltet, um eine hohe Strangspannung zu erreichen. Diese Spannung der zu Strängen zusammengeschalteten Solarmodule kann mehrere 100 V betragen, wobei für Großanlagen sogar Arbeitsspannungen von im Bereich von 1000 V oder sogar mehr vorliegen, was eine berührgefährliche Spannung darstellt. Ein Solarkraftwerk umfasst ferner ggf. mehrere parallel geschaltete Stränge.

Während der Montage der Solarmodule und deren elektrischer Verkabelung in dem Strang kann es bei entsprechender Beleuchtung demnach zu sehr hohen Spannungen kommen, die einen vorsichtigen Umgang bzw. einen besonderen Berührschutz notwendig machen. Gleiches gilt für die Wartung und Störfälle, wie z.B. bei einem Brand.

Bei solch einfachen Photovoltaik-Anlagen befindet sich die erste Möglichkeit die Solargeneratorspannung vom Netz zu trennen am Generatoranschlusskasten. Daher besteht bei Schäden durch Feuer, Wasser, Hagel oder anderen Störungen an den Solarmodulen oder den Strangleitungen bei diesen einfachen Solarmodulen keine Möglichkeit den Teil der Photovoltaik-Anlage mit den Solarmodulen und den Strangleitungen spannungsfrei zu schalten.

Es sind Sicherheitseinrichtungen bekannt, welche die einzelnen Solarmodule im Brand- oder Fehlerfall abschalten (z.B. DE 10 2009 024 516 A1). Solche Lösungen sind jedoch zumeist lediglich auf eine einmalige Notfallabschaltung ausgerichtet.

Aus der US2008/0106250 A1 ist ein Verfahren zur Überwachung eines Photovoltaik-Generators beschrieben, wobei eine Frequenzantwort im Frequenzspektrum detektiert wird, mit dem Strom als Eingangsvariable und einer elektrischen Variable des Generators als Ausgangsvariable. Diesem Verfahren liegt die Erkenntnis zugrunde, dass eine Änderung in der Frequenzantwort ein zuverlässiger Hinweis auf einen Diebstahl oder allgemeiner auf eine Manipulation am Solar-Generator ist.

Aus der EP 2 726 899 B1 ist ein Photovoltaik-Modul bekannt, welches eine sichere Abschaltung im Falle eines nicht verbauten oder angeschlossenen Moduls oder im Fehlerfall gewährleistet. Hierzu ist eine Baugruppe mit einer Prüfeinrichtung entweder direkt in die Anschlussdose des Photovoltaik-Moduls integriert oder lokal einem Photovoltaik-Modul zugeordnet. Um das Photovoltaik-Modul einzuschalten, überprüft die Prüfeinrichtung der Baugruppe, ob ein Fehlerfall noch vorliegt oder ob das individuelle Photovoltaik-Modul an einen Umrichter angeschlossen ist. Das Abschalten des Photovoltaik-Moduls erfolgt in jedem Fall lokal am Photovoltaik-Modul selbst, so dass die Baugruppe mit der Prüfeinrichtung in jedem Fall lokal an dem Photovoltaik-Modul angeordnet ist. Die Prüfeinrichtung lokal am einzelnen Photovoltaik-Modul vorzusehen ist allerdings aufwändig und daher nachteilig. Ferner ist hiermit prinzipiell keine zentrale Steuerung eines Strangs aus mehreren Photovoltaik-Modulen möglich. Darüber hinaus können hierbei Stoß- oder Impulsströme fließen, was sich nachteilig auf die Lebensdauer der Komponenten, die an dem Stromfluss beteiligt sind, auswirken kann. Weiterhin kann die Eingangskapazität des Wechselrichters relativ groß sein, was dazu führen kann dass die Quelle beim Einschalten möglicherweise nicht in der Lage ist, genug Energie zu liefern, so dass die Aufladung der Eingangskapazität nur begrenzt möglich ist.

Die DE 10 2011 110 682 A1 beschreibt eine Anschlussdose für ein Solarpanel mit einer Schutzschaltung, welche sich im Lieferzustand in einem Schutzzustand befindet sowie in einem Störfall in den Schutzzustand schaltet. In dem Schutzzustand sind die Solarzellen des Solarpanels vom Strang getrennt. Die Schutzschaltung hat zusätzlich den Vorteil, dass externe Anschlüsse z.B. der Anschlussdose im Schutzzustand kurzgeschlossen sind. Es wird somit sicher verhindert, dass in dem Schutzzustand z.B. an den externen Anschlüssen der Anschlussdose Spannung anliegen kann und trotzdem ist der Stromkreis des Strangs in dem Schutzzustand geschlossen, so dass andere Solarpanele ggf. weiter Solarleistung einspeisen können. Darüber hinaus ermöglicht dies aber auch die zentrale Prüfung und ggf. Steuerung des gesamten Strangs.

Aus der DE 10 2013 101 314 A1 und der WO 2014/122325 A1 ist ferner eine sichere Photovoltaik-Anlage bekannt, welche eine zentrale Startbox umfasst, die einen gesamten Strang aus einer Mehrzahl von seriell zusammengeschalteten Solarmodulen, die insbesondere jeweils eine Schutz- oder Sicherheitsschaltung umfassen, anschaltet, entweder beim erstmaligen Anschalten oder beim Wiederanschalten. Da an den Strangzuleitungen eines solchen Strangs aus einer Mehrzahl von Solarmodulen eine berührgefährliche Spannung von z.B. bis zu 1000 Volt oder mehr anliegen kann, prüft die Startbox, ob der Stromkreis über die Strangzuleitungen zwischen der Startbox und dem gesamten Strang aus der Mehrzahl von Solarmodulen, d.h. zwischen der Startbox und allen Sicherheitsschaltungen der Solarmodule geschlossen ist, um zu verhindern, dass eine berührgefährliche Offenspannung an möglicherweise offenen Kontakten zwischen der Startbox und den mehreren Sicherheitsschaltungen anliegen kann. Der Bereich zwischen der zentralen Startbox und dem Wechselrichter wird hiermit nicht geprüft. Hier setzt die vorliegende Erfindung an, welche insbesondere eine Weiterentwicklung einer Photovoltaik-Anlage mit Solarmodulen, die jeweils eine Sicherheitsschaltung aufweisen und einer Startbox gemäß der DE 10 2013 101 314 A1 und der WO 2014/122325 A1 ist.

### Allgemeine Beschreibung der Erfindung

Es ist daher eine Aufgabe der vorliegenden Erfindung, eine Photovoltaik-Anlage bereit zu stellen, welche hohen Sicherheitsanforderungen genügt, insbesondere welche einen gesicherten Zustand definiert und ein sicheres Umschalten vom gesicherten Zustand in den Betriebszustand, insbesondere nach Montage, Wartung, Sonnenaufgang und/oder Störfällen ermöglicht.

Ein weiterer Aspekt der Aufgabe ist es, sicherzustellen, dass der Stromkreis der Strangzuleitungen zwischen dem Wechselrichter und einer Startbox, welche an einer zentralen Stelle in die Strangzuleitungen geschaltet ist, an der im Betriebszustand die gesamte berührgefährliche Spannung des Strangs anliegt, geschlossen ist, bevor, zentral von der Startbox zentral gesteuert, alle Solarmodule in den Betriebszustand geschaltet werden.

Weitere Aspekte der Aufgabe ergeben sich aus der nachfolgenden Beschreibung bzw. den besonderen Vorteilen die mit bevorzugten Ausführungsformen erzielt werden.

Die Aufgabe wird durch den Gegenstand der unabhängigen Ansprüche gelöst. Vorteilhafte Ausführungsformen sind Gegenstand der abhängigen Ansprüche.

Die Erfindung betrifft eine Photovoltaik-Anlage mit zumindest einem Strang aus einer Mehrzahl von seriell zusammengeschalteten Solarmodulen und im fertig montierten Normalzustand mit einem Wechselrichter zum Umrichten des von dem Strang erzeugten Gleichstroms, z.B. zur Einspeisung in ein Stromnetz.

Im Normalzustand sind das positive Ende des Strangs aus der Mehrzahl von seriell zusammengeschalteten Solarmodulen mit einer Pluspol-Strangzuleitung an den Pluspol-Gleichstromeingang des Wechselrichters und das negative Ende des Strangs aus der Mehrzahl von seriell zusammengeschalteten Solarmodulen an einer Minuspol-Strangzuleitung an den Minuspol-Gleichstromeingang des Wechselrichters angeschlossen, welcher eine gleichstromseitige Kapazität besitzt. Mit anderen Worten sind die beiden Enden des Strangs mit jeweils einer Strangzuleitung mit dem zugehörigen Gleichstromeingang des Wechselrichters elektrisch verbunden und im Betriebszustand liegt zwischen den beiden Enden des Strangs eine berührgefährliche Spannung, nämlich die Gesamtspannung des gesamten seriellen Strangs an.

Ferner ist eine Prüfschaltung umfasst, welche zwischen das positive Ende des Strangs aus der Mehrzahl der seriell zusammengeschalteten Solarmodule und den Pluspol-Gleichstromeingang des Wechselrichters in die Pluspol-Strangzuleitung und/oder zwischen das negative Ende des Strangs aus der Mehrzahl der seriell zusammengeschalteten Solarmodule und den Minuspol-Gleichstromeingang des Wechselrichters in die Minuspol-Strangzuleitung geschaltet ist, so dass die Prüfschaltung strangseitig zumindest an eines der positiven und negativen Enden des gesamten Strangs aus der Mehrzahl der seriell zusammengeschalteten Solarmodule und wechselrichterseitig, d.h. auf der der strangseitigen Seite gegenüberliegenden Seite der Prüfschaltung an zumindest einen der Pluspol- und Minuspol-Gleichstromeingänge angeschlossen ist. Die Prüfschaltung ist also an einer Stelle zwischen die Strangzuleitungen geschaltet, an welcher die gesamte Strangspannung anliegen kann, so dass im Betriebszustand der Photovoltaik-Anlage an der Prüfschaltung die gesamte Strangspannung anliegt. Mit anderen Worten ist die Prüfschaltung an zentraler Stelle zwischen den Strang aus der Mehrzahl von seriell zusammengeschalteten Solarmodulen und den Wechselrichter geschaltet. Ggf. steuert die Prüfschaltung ferner zentral alle intelligenten Solarmodule des Strangs.

Die Prüfschaltung weist zumindest einen ersten Schalter zum Trennen der Pluspol-Strangzuleitung zwischen dem positiven Ende des Strangs und dem Pluspol-Gleichstromeingang des Wechselrichters oder zum Trennen der Minuspol-Strangzuleitung zwischen dem negativen Ende des Strangs und dem Minuspol-Gleichstromeingang des Wechselrichters auf.

Der Strang definiert nun vorzugsweise neben dem Betriebszustand, in welchem die Solarleistung an den Wechselrichter abgegeben und ins Netz eingespeist wird, einen gesicherten Zustand, in welchem zumindest die meisten Solarmodule abgeschaltet sind, so dass der Strang maximal eine nicht berührgefährliche Spannung an die Strangzuleitungen anlegt. Dies wird insbesondere dadurch erreicht, dass zumindest die meisten der Solarmodule des seriellen Strangs mit einer Sicherheitsschaltung gemäß der WO 2014/122325 A1 ausgerüstet sind.

Der Strang kann mittels dieser Sicherheitsschaltungen automatisch vom Betriebszustand in den gesicherten Zustand umschalten, z.B. wenn es Nacht wird, oder der Strang kann manuell vom Betriebszustand in den gesicherten Zustand umgeschaltet werden, z.B. für Wartungsmaßnahmen. Wenn sich der Strang in dem gesicherten Zustand befindet und wieder in den Betriebszustand schalten soll, z.B. morgens bei Sonnenaufgang oder nach Abschluss von Wartungsarbeiten, dann sollen die Sicherheitsschaltungen allesamt wieder in den Betriebszustand versetzt werden. Dies kann insbesondere mit einer Startbox gemäß der WO 2014/122325 A1 für den gesamten Strang durchgeführt werden. Die Startbox prüft hierzu den Stromfluss über die Strangzuleitungen zwischen der Startbox und den Solarmodulen. Die vorliegende Erfindung betrifft nun die, insbesondere vorgelagerte, Prüfung der wechselrichterseitigen Strangzuleitungen. Demnach führt die zentrale Prüfschaltung zunächst einen von der Prüfschaltung gesehen wechselrichterseitigen Prüfprozess durch, um zu Überprüfen, ob der Wechselrichter momentan tatsächlich an die Strangzuleitungen angeschaltet ist und ob der wechselrichterseitige Abschnitt der Strangzuleitungen geschlossen, also nicht unterbrochen ist. Hierzu öffnet die Prüfschaltung den seriell in eine der beiden Strangzuleitungen geschalteten ersten Schalter. Dadurch wird die gleichstromseitige Kapazität des Wechselrichters zumindest einseitig von dem Strang und/oder von einer Spannungsversorgung der Prüfschaltung elektrisch getrennt. Diese Trennung führt zu einem Spannungsabfall zwischen den beiden wechselstromseitigen Ausgängen der Prüfschaltung. In Ansprechen auf den zeitlichen Verlauf des durch das elektrische Trennen der gleichstromseitigen Kapazität des Wechselrichters von dem Strang und/oder von der Spannungsversorgung der Prüfschaltung an der gleichstromseitigen Kapazität des Wechselrichters ausgelösten Spannungsabfall kann die Prüfschaltung bestimmen, ob der Wechselrichter zum Zeitpunkt des Öffnens des ersten Schalters momentan tatsächlich an die Strangzuleitungen angeschaltet ist und ob der wechselrichterseitige Abschnitt der Strangzuleitungen unterbrochen ist oder nicht.

Gründe dafür, dass der Wechselrichter momentan gerade nicht angeschaltet ist können z.B. sein, dass der Wechselrichter beim Aufbau der Anlage noch gar nicht angeschlossen wurde oder dass der DC-Trennschalter aktiviert wurde, so dass am gleichstromseitigen Eingang des Wechselrichters eine galvanische Trennung vorliegt.

Mit anderen Worten handelt es sich um eine zentrale, Solarmodul-übergreifende, für den gesamten Strang zuständige Prüfschaltung, um zu überprüfen, ob der Wechselrichter momentan tatsächlich angeschaltet ist und/oder ob der von der Prüfschaltung aus gesehen wechselrichterseitige Abschnitt der Strangzuleitungen geschlossen, also nicht unterbrochen ist. Dies hat den Vorteil, dass lediglich eine einzige Prüfschaltung für den gesamten Strang aus einer Mehrzahl von seriell zusammengeschalteten Solarmodulen eingesetzt wird und die Freigabe bzw. das Anschalten des gesamten Strangs zentral gesteuert werden kann.

Die Bestimmung in Ansprechen auf den Spannungsabfall nach Trennung der gleichstromseitigen Eingangskapazität ist einfach durchzuführen und zuverlässig.

Ferner wird die Eingangskapazität des Wechselrichters vorzugsweise langsam durch die Solarmodule aufgeladen und dann zur Messung des Spannungsabfalls vom Strang getrennt. In vorteilhafter Weise fließen hierbei keine Stoß- oder Impulsströme, was eine lange Lebensdauer der Komponenten, die an dem Stromfluss beteiligt sind, gewährleistet.

Weiterhin kann die Eingangskapazität des Wechselrichters relativ groß sein, so dass die Quelle beim Einschalten möglicherweise nicht in der Lage wäre, genug Energie zu liefern und die Aufladung der Eingangskapazität daher nur begrenzt möglich wäre. Dadurch dass bei der Erfindung der Spannungsabfall beim Entladeprozess genutzt wird, treten in vorteilhafter Weise diese Probleme nicht auf.

Die Prüfschaltung kann dazu ausgebildet sein, in Abhängigkeit des Prüfergebnisses den Strang aus dem gesicherten Zustand in den Betriebszustand zu versetzen, also freizugeben, oder umgekehrt, so dass die Prüfschaltung vorzugsweise eine Prüf- und Freigabeschaltung bildet.

Die Photovoltaik-Anlage umfasst ferner eine Trennvorrichtung oder DC-Trennvorrichtung, mittels welcher der wechselrichterseitige Abschnitt der Strangzuleitungen unterbrochen werden kann. Diese Trennvorrichtung wird auch als "Feuerwehr-Notschalter" bezeichnet und kann in den Wechselrichter integriert oder als separate Einheit ausgebildet sein.

Wenn das Ergebnis der Bestimmung des Spannungsabfalls in dem wechselrichterseitigen Prüfprozess ergibt, dass der Wechselrichter zum Zeitpunkt des Öffnens des ersten Schalters an die Strangzuleitungen angeschaltet ist, kann die Prüfschaltung demnach weitere Prüf- und/oder Anschaltprozesse in dem Strang, z.B. an den Solarmodulen auslösen, um den Strang aus dem gesicherten Zustand in den Betriebszustand zu versetzen. Dies kann z.B. bedeuten, dass die Prüfschaltung anschließend einen weiteren strangseitigen Prüfprozess, insbesondere gemäß der WO 2014/122325 A1, durchführt und bei positivem Ergebnis die einzelnen Sicherheitsschaltungen an den Solarmodulen in den Betriebszustand versetzt. Mit anderen Worten kann die hiesige Prüfschaltung einen Teil der zentralen Startbox zwischen dem Strang und dem Wechselrichter gemäß der WO 2014/122325 A1 bilden.

Wenn jedoch bereits das Ergebnis der Bestimmung des Spannungsabfalls ergibt, dass der Wechselrichter zum Zeitpunkt des Öffnens des ersten Schalters nicht an die Strangzuleitungen angeschaltet ist oder der wechselrichterseitige Abschnitt der Strangzuleitungen unterbrochen ist, setzt die Prüfschaltung weder den strangseitigen Prüfprozess in Gang noch versetzt sie den Strang in den Betriebszustand, sondern schließt den ersten Schalter wieder. Nach einer vorbestimmten Zeit wird dann der wechselrichterseitige Prüfprozess automatisch wiederholt. Dies geschieht so oft, bis das Ergebnis der Bestimmung des Spannungsabfalls nach dem Trennen ergibt, dass der Wechselrichter zum Zeitpunkt des Öffnens des ersten Schalters an die Strangzuleitungen angeschaltet ist und/oder der wechselrichterseitige Abschnitt der Strangzuleitungen geschlossen ist. Der wechselrichterseitige Prüfprozess wird demnach automatisch regelmäßig wiederholt, bis das Ergebnis positiv ist, um dann automatisch die strangseitigen Prüf- und/oder Anschaltprozesse durchzuführen.

Vorzugsweise bestimmt die Prüfschaltung den Spannungsabfall durch einen Vergleich der Spannungen vor und nach dem Öffnen des ersten Schalters und/oder durch eine Spannungsverlaufsmessung nach dem Öffnen des ersten Schalters. Z.B. kann die Spannung kurz vor dem Öffnen des ersten Schalters mit der Spannung zu einem definierten Zeitpunkt, z.B. einige Millisekunden nach dem Öffnen des Schalters verglichen werden, was einfach und zuverlässig zu bewerkstelligen ist.

Da dem gesamten Strang aus der Mehrzahl aus seriell zusammengeschalteten Solarmodulen insbesondere eine einzige Prüfschaltung für alle Solarmodule zugeordnet ist, ist die Prüfschaltung insbesondere entfernt von den Solarmodulen in die Pluspol-Strangzuleitung und/oder die Minuspol-Strangzuleitung geschaltet. Dies hat z.B. den Vorteil, dass die Prüfschaltung nahe dem bzw. direkt vor dem Wechselrichter in die Strangzuleitungen geschaltet sein kann, so dass sie z.B. nicht schwer zugänglich auf dem Dach positioniert sein muss, sondern innerhalb des Gebäudes und somit gut zugänglich für den Benutzer positioniert sein kann.

Vorzugsweise wird die Prüfschaltung von einer Startbox beherbergt und die Startbox ist zwischen das positive Ende des Strangs aus der Mehrzahl der seriell zusammengeschalteten Solarmodule und den Pluspol-Gleichstromeingang des Wechselrichters in die Pluspol-Strangzuleitung und zwischen das negative Ende des Strangs aus der Mehrzahl der seriell zusammengeschalteten Solarmodule und den Minuspol-Gleichstromeingang des Wechselrichters in die Minuspol-Strangzuleitung geschaltet, so dass die Pluspol-Strangzuleitung und die Minuspol-Strangzuleitung elektrisch durch die Startbox geleitet werden. In vorteilhafter Weise kann die Prüfschaltung in der Startbox gemäß der WO 2014/122325 A1 integriert sein, so dass die Startbox die Strangzuleitungen strangseitig und wechselrichterseitig der Startbox und die momentan tatsächliche Anschaltung des Wechselrichters prüft.

Demnach ist die Startbox mit der Prüfschaltung entfernt von den Solarmodulen in die Pluspol-Strangzuleitung und/oder die Minuspol-Strangzuleitung geschaltet ist, so dass die Pluspol-Strangzuleitung von einem strangseitigen Kabelabschnitt, welcher sich von dem positiven Ende des Strangs bis zu der Startbox erstreckt und einem wechselrichterseitigen Kabelabschnitt, welcher sich von der Startbox bis zu dem Pluspol-Gleichrichtereingang erstreckt und/oder die Minuspol-Strangzuleitung von einem strangseitigen Kabelabschnitt, welcher sich von dem negativen Ende des Strangs bis zu der Startbox erstreckt und einem wechselrichterseitigen Kabelabschnitt, welcher sich von der Startbox bis zu dem Minuspol-Gleichrichtereingang erstreckt, gebildet werden.

Vorzugsweise umfasst die Prüfschaltung einen strangseitig des seriellen ersten Schalters angeordneten zweiten Schalter, welcher die erste und zweite Strangzuleitung strangseitig des ersten Schalters kurzschließt, wenn in dem wechselrichterseitigen Prüfprozess der Spannungsabfall an der gleichstromseitigen Eingangskapazität des Wechselrichters bestimmt wird. In vorteilhafter Weise kann hierdurch verhindert werden, dass die Messung des Spannungsabfalls von einer eventuellen nicht berührgefährlichen Spannung des Strangs über eine optional vorhandene zu dem ersten Schalter parasitäre Diode gestört wird.

Der erste und zweite Schalter sind vorzugsweise dieselben Schalter wie der Nebenschlussschalter 53 und der Freischalter 54 gemäß der WO 2014/122325 A1.

Gemäß einer bevorzugten Ausführungsform der Erfindung sind der erste und/oder zweite Schalter als Halbleiterschaltelemente, insbesondere als FETs ausgebildet.

Vorzugsweise ist der erste FET-Schalter als Öffner ausgebildet, der im Normalzustand geschlossen ist und/oder der zweite FET-Schalter ist als Schließer ausgebildet, der im Normalzustand geöffnet ist. In vorteilhafter Weise ist die Prüfschaltung bzw. die Startbox demnach im Normalzustand des ersten und/oder zweiten Schalters im Betriebszustand und hält die gleichstromseitige Kapazität des Wechselrichters somit geladen.

Die Solarmodule umfassen jeweils eine Solaranschlussdose, mittels welchen die Anschlusselemente oder Anschlussbändchen des zugehörigen Solarmoduls kontaktiert sind. Zumindest einige der Solarmodule weisen eine Sicherheitsschaltung auf weisen, welche einen Betriebszustand und einen Sicherheitszustand definieren, wobei das jeweilige Solarmodul in dem Betriebszustand Solarstrom in die Strangzuleitungen einspeist und in dem Sicherheitszustand keinen Solarstrom in die Strangzuleitungen einspeist.

Vorzugsweise weist der Strang eine Mehrzahl von Solarmodulen mit der Sicherheitsschaltung auf, die diese Solarmodule bei Dunkelheit, in einem Störfall oder durch Benutzereingriff vom Betriebszustand in den Sicherheitszustand, in dem das jeweilige Solarmodule keine Spannung an die Strangleitungen anlegt, versetzen. Diese Solarmodule mit der Sicherheitsschaltung werden auch als intelligente Solarmodule bezeichnet.

Der Strang kann gemäß einer ersten Alternative ausschließlich intelligente Solarmodule umfassen. In diesem Fall weist die Startbox ein eigens Netzteil bzw. eine eigene Spannungsversorgung auf, um in dem gesicherten Zustand die elektronischen Bauteile der Startbox zu versorgen und die gleichstromseitige Eingangskapazität geladen zu halten.

Gemäß einer zweiten Alternative weist der Strang eine Mehrzahl an intelligenten Solarmodulen und zumindest ein Start-Solarmodul auf, welches nicht aktiv in den Betriebszustand geschaltet werden muss, sondern bei entsprechender Einstrahlung automatisch Spannung an die Strangleitungen anlegt und damit die Startbox bzw. die Prüfschaltung mit elektrischem Strom versorgt, auch dann wenn die intelligenten Solarmodule des Strangs sich in dem Sicherheitszustand befinden. Wenn z.B. ein Strang 20 Solarmodule mit jeweils 40 V Nennspannung enthält, sind z.B. 19 Solarmodule intelligent und ein Solarmodul enthält keine Sicherheitsschaltung, bildet also das Start-Solarmodul. In dem Sicherheitszustand befinden sich demnach die 19 intelligenten Solarmodule im Sicherheitszustand, so dass lediglich das eine Start-Solarmodul die Startbox bzw. die Prüfschaltung mit hinreichender elektrischer Spannung versorgt. Daher ist im gesicherten Zustand zwar photovoltaisch erzeugte elektrische Leistung aus dem Strang vorhanden, die Spannung liegt aber trotzdem unterhalb der Schwelle für berührgefährliche Spannung, obwohl der gesamte Strang im Betriebszustand 800 V Nennspannung liefert, also eine berührgefährliche Spannung.

Wenn das Ergebnis der Bestimmung des Spannungsabfalls in dem wechselrichterseitigen Prüfprozess ergibt, dass der Wechselrichter zum Zeitpunkt des Öffnens des ersten Schalters an die Strangzuleitungen angeschaltet ist und der wechselrichterseitige Abschnitt der Strangzuleitungen geschlossen ist, löst die Prüfschaltung einen strangseitigen Prüfprozess aus, welcher prüft, ob der von der Prüfschaltung aus gesehen strangseitige Stromkreis der Strangzuleitungen geschlossen ist und bei positivem Prüfergebnis die Sicherheitsschaltungen der intelligenten Solarmodule in den Betriebszustand versetzt, so dass dann der gesamte Strang, d.h. alle Solarmodule, elektrische Leistung an den Wechselrichter liefert. Das Umschalten der Sicherheitsschaltungen der intelligenten Solarmodule erfolgt vorzugsweise mit einem gewissen Delay, damit nach dem strangseitigen Prüfprozess sichergestellt ist, dass vor dem Umschalten in den Betriebszustand der erste Schalter geschlossen und der zweite Schalter geöffnet ist.

Mit anderen Worten kann die Prüfschaltung, die in diesem Fall als Prüf- und Freigabeschaltung bezeichnet werden kann, in Ansprechen auf das Prüfergebnis, d.h. insbesondere bei positivem Prüfergebnis, den Strang aus dem gesicherten Zustand in den Betriebszustand versetzen, also freigeben. Dies kann dadurch erfolgen, dass die Prüf- und Freigabeschaltung in Ansprechen auf das Prüfergebnis, d.h. insbesondere bei positivem Prüfergebnis die Sicherheitsschaltungen der intelligenten Solarmodule in den Betriebszustand versetzt. Die Prüf- und Freigabeschaltung kann dabei den Strang bzw. die Sicherheitsschaltungen der intelligenten Solarmodule nach einem oder mehreren weiteren Prüfprozessen, z.B. wie vorstehend beschrieben nach einem strangseitigen Prüfprozess, in den Betriebszustand versetzen. Es soll aber nicht ausgeschlossen sein, dass die Freigabe auch ohne weitere Prüfprozesse, also direkt, erfolgen kann.

Wenn ein Strang, bei welchem eine Mehrzahl von intelligenten Solarmodulen und zumindest ein Start-Solarmodul seriell zusammengeschaltet sind, verwendet wird, wird die gleichstromseitige Kapazität des Wechselrichters vor dem wechselrichterseitigen Prüfprozess bzw. vor dem Öffnen des ersten Schalters von dem zumindest einen Start-Solarmodul geladen gehalten, um die Ladung der gleichstromseitigen (Eingangs-)Kapazität des Wechselrichters für den wechselrichterseitigen Prüfprozess zum Zeitpunkt des Öffnens des ersten Schalters zu gewährleisten. Wenn ein Strang verwendet wird, welcher ausschließlich intelligente Solarmodule enthält, wird die gleichstromseitige Kapazität des Wechselrichters vor dem wechselrichterseitigen Prüfprozess bzw. vor dem Öffnen des ersten Schalters von einer Spannungsversorgung der Prüfschaltung geladen gehalten, um die Ladung der gleichstromseitigen Kapazität des Wechselrichters für den wechselrichterseitigen Prüfprozess zum Zeitpunkt des Öffnens des ersten Schalters zu gewährleisten.

Gegenstand der Anmeldung ist auch die Prüfschaltung zur Durchführung des wechselrichterseitigen Prüfprozesses und/oder zur Durchführung des strangseitigen Prüfprozesses und/oder zum Umschalten der intelligenten Solarmodule vom Sicherheitszustand in den Betriebszustand.

Weiterer Gegenstand der Anmeldung ist das Prüfverfahren für die Photovoltaik-Anlage zum Überprüfen, ob der Wechselrichter momentan tatsächlich an die Strangzuleitungen angeschaltet ist und/oder ob der wechselrichterseitige Abschnitt der Strangzuleitungen geschlossen ist, wobei in dem gesicherten Zustand der Photovoltaik-Anlage (Solarmodule im Sicherheitszustand), in welchem zumindest einige der Solarmodule des Strangs abgeschaltet sind, derart dass der Strang in dem gesicherten Zustand keine berührgefährliche Spannung an die Strangzuleitungen anlegt, folgende Schritte durchgeführt werden:
a) Vor dem wechselrichterseitigen Prüfprozess, aber in dem gesicherten Zustand wird die Ladung der gleichstromseitigen Kapazität des Wechselrichters mit einer gegenüber der Strangspannung erheblich reduzierten nicht berührgefährlichen Startspannung mit dem Start-Solarmodul oder einer Spannungsversorgung der Prüfschaltung aufrechterhalten, nachfolgend
b) noch immer in dem gesicherten Zustand wird der wechselrichterseitige Prüfprozess durchgeführt, bei welchem die gleichstromseitige Kapazität des Wechselrichters zumindest einseitig von der Startspannung getrennt wird, und
c) noch immer in dem gesicherten Zustand wird in Ansprechen auf den durch das Trennen der gleichstromseitigen Kapazität des Wechselrichters an der gleichstromseitigen Kapazität des Wechselrichters ausgelösten Spannungsabfall bestimmt, ob der Wechselrichter momentan tatsächlich an die Strangzuleitungen angeschaltet ist und/oder ob der wechselrichterseitige Abschnitt der Strangzuleitungen geschlossen ist oder nicht.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele miteinander kombiniert werden können.

### Kurzbeschreibung der Figuren

Es zeigen:
- Fig. 1: eine perspektivische Darstellung einer typischen Solaranschlussdose,
- Fig. 2: ein Blockschaltbild eines Solarmoduls mit intelligenter Solaranschlussdose im Betriebszustand,
- Fig. 3: wie Fig. 2, aber im Sicherheitszustand,
- Fig. 4: ein vereinfachtes Übersichts-Blockschaltbild einer Photovoltaik-Anlage mit einem Strang aus seriell zusammengeschalteten Solarmodulen, einer Startbox und einem Wechselrichter,
- Fig. 5: ein Blockschaltbild eines Ausführungsbeispiels der Startbox mit Prüfschaltung an einem Strang aus seriell zusammengeschalteten intelligenten Solarmodulen und einem Start-Solarmodul,
- Fig. 6: ein detaillierteres Blockschaltbild der Startbox aus Fig. 5,
- Fig. 7: ein Blockschaltbild eines Ausführungsbeispiels der Startbox mit Prüfschaltung an einem Strang aus seriell zusammengeschalteten ausschließlich intelligenten Solarmodulen,
- Fig. 8: ein detaillierteres Blockschaltbild der Startbox aus Fig. 7,
- Fig. 9: am wechselrichterseitigen Ausgang der Startbox gemessene Spannungsabfälle,
- Fig. 10: ein Ablaufdiagramm der Prüf- und Freigabeprozesse in der Photovoltaik-Anlage.

### Detaillierte Beschreibung der Erfindung

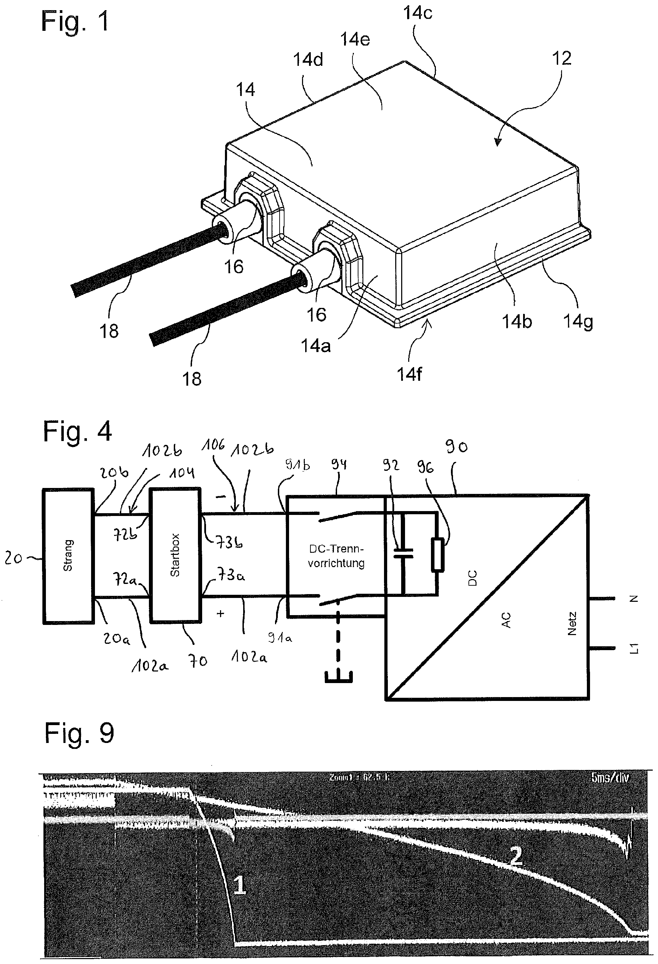

Fig. 1 zeigt eine Solaranschlussdose 12, manchmal auch als "Junctionbox" bezeichnet, mit einem Anschlussdosengehäuse 14 zur Montage auf der Rückseite eines Solarmoduls. Das dielektrische Anschlussdosengehäuse 14 ist hutartig ausgebildet und weist umlaufende Seitenwände 14a bis 14d sowie einen Deckel 14e auf. An der in Fig. 1 nicht zu sehenden Unterseite 14f des Anschlussdosengehäuses 14 befinden sich Öffnungen, durch welche die aus dem Solarmodul heraustretenden Leiterbänder in die Solaranschlussdose 12 eintreten, um dort kontaktiert zu werden. Das Anschlussdosengehäuse 14 weist an einer der Seitenwände 14a zwei Kabeldurchführungen 16 auf, durch welche die Strangleitung 18 in die Solaranschlussdose 12 geführt und im Inneren des Anschlussdosengehäuses 14 zum Beispiel mittels nicht dargestellter Kontaktklemmen angeschlossen ist, um die von dem Solarmodul erzeugte elektrische Leistung abzuführen. Ein Rand 14g dient zum Aufkleben der Solaranschlussdose auf dem Solarmodul. Zum grundsätzlichen konstruktiven Aufbau von Solaranschlussdosen wird ferner auf die DE 10 2007 037 130 A1 und die DE 10 2007 042 547 bzw. DE 10 2007 051 134 A1 verwiesen.

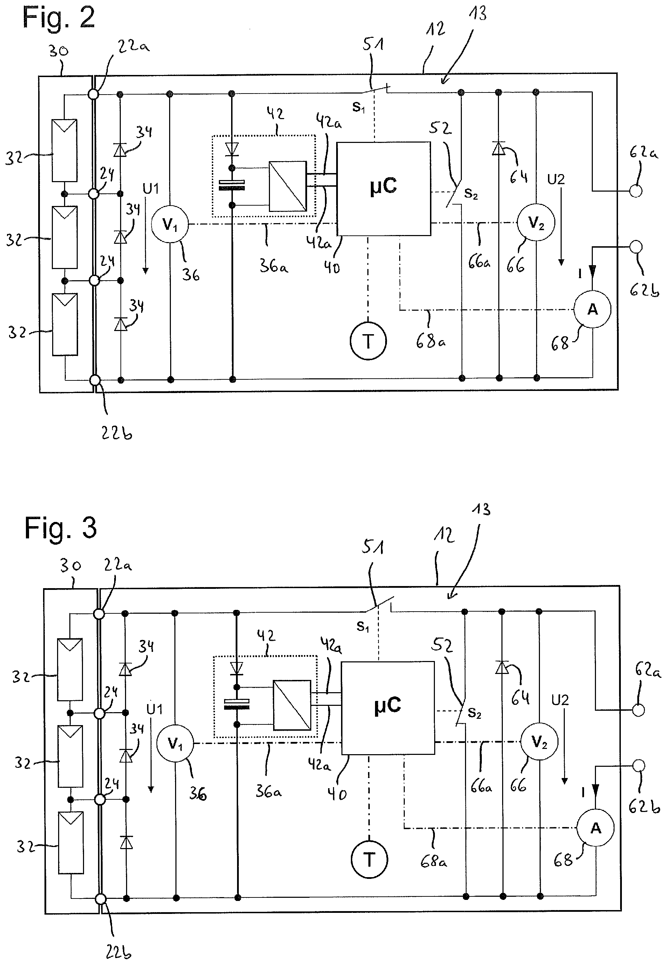

Fig. 2 zeigt ein Blockschaltbild der Solaranschlussdose 12, welche mit eingangsseitigen Plus- und Minus-Anschlusselementen 22a, 22b sowie in diesem Beispiel mit zwei Zwischenabgriffen 24 mit den entsprechenden Leiterbändern des Solarmoduls 30 verbunden sind. Parallel zu den Solarzellen oder Solarmodulteilen 32 sind Bypass-Dioden 34 geschaltet, um Teilabschattungen des Solarmoduls 30 kompensieren zu können.

Die Solaranschlussdose 12 umfasst eine Sicherheitsschaltung 13, welche die Solaranschlussdose 12 vom Betriebszustand in den Sicherheitszustand und umgekehrt schalten kann und nachfolgend genauer beschrieben wird. In dem in Fig. 2 und 3 dargestellten Beispiel ist die Sicherheitsschaltung 13 unmittelbar in der Solaranschlussdose 12 integriert. Es ist jedoch auch möglich, insbesondere bei Nachrüstkonzepten, die Sicherheitsschaltung 13 in einem separaten Gehäuse (nicht dargestellt) in der Nähe der Solaranschlussdose 12 an dem zugehörigen Solarmodul 30 anzubringen. Auch in diesem Fall ist aber vorzugsweise jedem Solarmodul 30 eine eigene Sicherheitsschaltung 13 zugeordnet, welche das jeweilige Solarmodul 30 jeweils einzeln stromabwärts der Sicherheitsschaltung 13 abschalten kann. Solche Solarmodule 30 mit jeweils individuell zugeordneter Sicherheitsschaltung 13 werden hierin auch als intelligente Solarmodule 30 bezeichnet.

Ein parallel zu dem Solarmodul 30 geschalteter Spannungssensor 36 (V₁) misst die Modulspannung U1 und wird über die Verbindung 36a von einer Steuereinrichtung in Form eines Mikrocontrollers 40 ausgelesen. Ferner parallel zu dem Solarmodul 30 ist eine Energieversorgungseinrichtung 42 geschaltet, welche den Mikrocontroller 40 über Versorgungsleitungen 42a mit Energie versorgt, damit dieser die Solaranschlussdose 12 steuern kann. Seriell zu dem Solarmodul 30 ist in der Solaranschlussdose 12 ein serieller Freischalter 51 (S1) eingebaut, welcher in dem in Fig. 2 dargestellten Betriebszustand geschlossen ist, um die von dem Solarmodul 30 photovoltaisch erzeugte Leistung über die Strangverkabelung abzuführen. Ausgangsseitige Plus- und Minus-Anschlusselemente 62a, 62b sind mit einem Kurzschlussschalter 52 (S2) in der Solaranschlussdose 12 kurzschließbar, wobei der Kurzschlussschalter 52 in dem Betriebszustand geöffnet ist. Eine zentrale Bypass-Diode 64 zwischen den Plus- und Minus-Anschlusselementen 62a, 62b und dem Kurzschlussschalter 52 erzeugt einen weiteren Bypass, zum Beispiel für den Fall einer Fehlfunktion des Kurzschlussschalters 52.

Ein ausgangsseitiger Spannungssensor 66 misst die Strangspannung (U2), unabhängig vom Schaltzustand der Schalter 51 und 52, und wird über die Verbindung 66a von dem Mikrocontroller 40 ausgelesen. Ein Stromsensor 68 misst einerseits in dem in Fig. 2 dargestellten Betriebszustand den Strangstrom und andererseits in dem in Fig. 3 dargestellten Sicherheitszustand einen Startstrom, bzw. detektiert ein Startsignal und wird über die Verbindung 68a von dem Mikrocontroller 40 ausgelesen. Der Mikrocontroller 40 liest den eingangsseitigen Spannungssensor 36, den ausgangsseitigen Spannungssensor 66 und den Stromsensor 68 aus und steuert in Ansprechen auf die Messwerte den Freischalter 51 und den Kurzschlussschalter 52.

Fig. 3 zeigt ein Blockschaltbild des intelligenten Solarmoduls 30 in dem Sicherheitszustand. Im Sicherheitszustand ist der Freischalter 51 geöffnet und der Kurzschlussschalter 52 geschlossen, so dass das intelligente Solarmodul 30 einerseits von dem Strang 20 getrennt ist und der Strang 20 mittels des Kurzschlussschalters 52 geschlossen ist. Auch in dem Sicherheitszustand wird die Energieversorgung 42 von dem zugehörigen Solarmodul 30 mit Energie versorgt, sofern das Solarmodul 30 beleuchtet wird. Die Energieversorgung 42 wiederum versorgt den Mikrocontroller 40, so dass dieser auch im Sicherheitszustand in Betrieb bleibt, solange die Einstrahlung ausreicht. Mit anderen Worten kann der Mikrocontroller 40 auch in dem in Fig. 3 dargestellten Sicherheitszustand die ein- und/oder ausgangsseitigen Spannungssensoren 36, 66 und/oder insbesondere den Stromsensor 68 auslesen und/oder die Schalter 51 und/oder 52 steuern. Vorzugsweise ist der Freischalter 51 als Schließer und/oder der Kurzschlussschalter 52 als Öffner ausgebildet, so dass der in Fig. 3 dargestellte Sicherheitszustand dem Ruhezustand der Schalter 51, 52 entspricht. Dies hat den Vorteil, dass spätestens wenn das Solarmodul mangels hinreichender Einstrahlung nicht mehr genug Leistung zum Versorgen des Mikrocontrollers 40 liefert, die intelligenten Solarmodule 30 automatisch in den Sicherheitszustand schalten.

Wenn sich nun alle Solarmodule 30 eines Strangs 20 im Sicherheitszustand befinden, bedeutet dies, dass kein photovoltaisch erzeugter Strom fließt und der Sicherheitszustand nicht ohne Weiteres verlassen wird, selbst dann, wenn zum Beispiel die Sonne aufgeht und die Einstrahlung hinreichend stark ist. Ein einfaches Öffnen des Kurzschlussschalters 52 und Schließen des Freischalters 51 würde dazu führen, dass eine berührgefährliche Spannung entstehen kann, wenn dies mehrere intelligente Solarmodule 30 zur selben Zeit machen würden. Daher wird zum Freigeben und Anschalten der intelligenten Solarmodule 30 ein Startstrom von einer in Bezug auf die Solarmodule externen zentralen Startbox 70 in den auch im Sicherheitszustand der Solarmodule 30 geschlossenem Strang 20 eingeprägt.

Bezug nehmend auf Fig. 4 ist die Startbox 70 an das positive und negative Ende 20a, 20b des Strangs 20 bestehend aus einer Mehrzahl von seriell zusammengeschalteten Solarmodulen mit jeweils einer Strangzuleitung 102a, 102b angeschlossen. In diesem Beispiel ist die Startbox 70 demnach in beide Strangzuleitungen, d.h. in die Pluspol-Strangzuleitung 102a, und in die Minuspol-Strangzuleitung 102b - d.h. beidseitig zweipolig - in Reihe zwischen den Strang 20, der als serielle Kette aus den Solarmodulen 30 mit den jeweils zugeordneten Sicherheitsschaltungen 13 gebildet wird, und den Wechselrichter 90 geschaltet. Hierzu ist die Startbox 70 über zwei strangseitige Eingangsanschlüsse 72a, 72b mit dem Strang 20, bestehend aus einer Mehrzahl von Solarmodulen, von denen zumindest einige intelligent sind, verbunden und über die beiden wechselrichterseitigen Ausgangsanschlüsse 73a, 73b ist die Startbox 70 mit dem Pluspol-Gleichstromeingang 91a und dem Minuspol-Gleichstromeingang 91b des Wechselrichters 90 verbunden. Mit anderen Worten ist die Startbox 70 strangseitig mit dem positiven und negativen Ende 20a, 20b des Strangs 20 verbunden, so dass im Betriebszustand an der Startbox 70 die Spannung des gesamten Strangs 20 und damit eine berührgefährliche Spannung anliegt. Dies können je nach Größe und Anzahl der seriell zusammengeschalteten Solarmodule z.B. bis zu 1000 V oder mehr sein.

Somit unterteilt die Startbox 70 die Pluspol-Strangzuleitung 102a und die Minuspol-Strangzuleitung 102b, welche das positive Ende 20a des Strangs 20 mit dem Pluspol-Gleichstromeingang 91a des Wechselrichters 90 bzw. das negative Ende 20b des Strangs 20 mit dem Minuspol-Gleichstromeingang 91b des Wechselrichters 90 verbinden, in einen strangsseitigen Abschnitt 104 zwischen den beiden Enden 20a, 20b des Strangs 20 und der Startbox 70 und einen wechselrichterseitigen Abschnitt 106 zwischen der Startbox 70 und dem Wechselrichter 90. D.h. dass die Startbox 70 eine für den Strang 20 aus mehreren seriell zusammengeschalteten Solarmodulen zentrale Komponente darstellt und entfernt von den einzelnen Solarmodulen angeordnet ist, eher in der Nähe des Wechselrichters 90, und dass an der Startbox 70 im Betriebszustand die berührgefährliche Spannung des gesamten Strangs 20 anliegt, bzw. der strangseitige und der wechselrichterseitige Kabelabschnitt 104, 106 der Strangzuleitungen 102a, 102b die berührgefährliche Spannung des gesamten Strangs 20 führen.

In der WO 2014/122325 A1 wird ein Verfahren beschrieben, um den strangseitigen Abschnitt 104 der Strangzuleitungen 102a, 102b zu prüfen. Die vorliegende Erfindung betrifft nun insbesondere die Prüfung des wechselrichterseitigen Abschnitts 106 der Strangzuleitungen 102a, 102b. Dieser wechselrichterseitige Abschnitt 106 wird in einem wechselrichterseitigen Prüfprozess geprüft, bevor weitere Prüf- und Anschaltprozesse, insbesondere solche wie in der WO 2014/122325 A1 beschrieben, durchgeführt werden, um sicherzustellen, dass an dem wechselrichterseitigen Abschnitt 106 der Strangzuleitungen 102a, 102b keine berührgefährliche Offenspannung entstehen kann.

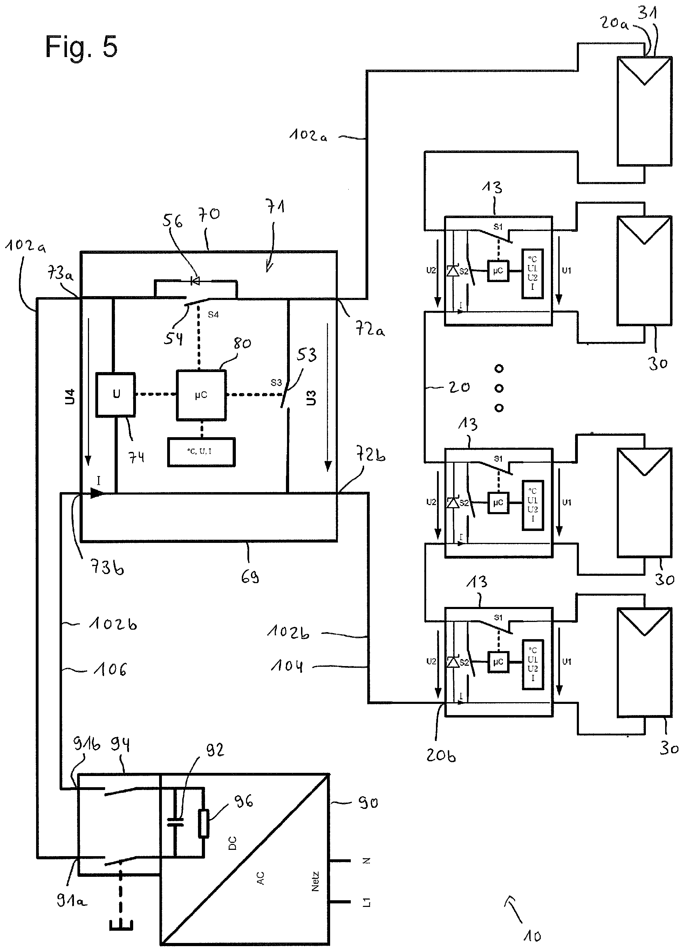

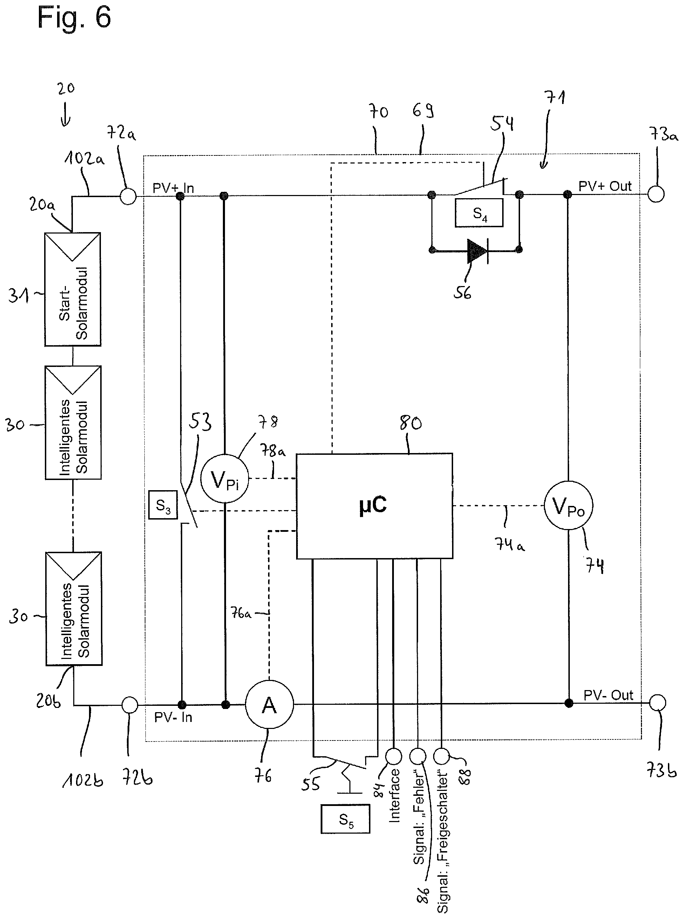

Bezug nehmend auf die Fig. 5 und 6 besteht der Strang 20 aus einer Mehrzahl von intelligenten Solarmodulen 30, d.h. Solarmodulen 30 mit je einer Sicherheitsschaltung 13, und einem Solarmodul 31 ohne eine solche Sicherheitsschaltung 13. Nach Sonnenuntergang oder bei Wartungsarbeiten schalten die Sicherheitsschaltungen 13 der intelligenten Solarmodule 30 automatisch in den Sicherheitszustand, so dass diese ohne weitere Prüf- und Anschaltprozesse keine Spannung an den Strang anlegen auch wenn z.B. die Sonne wieder aufgeht. Dieser Zustand des Strangs 20, in dem alle intelligenten Solarmodule 30 im Sicherheitszustand sind, wird als gesicherter Zustand bezeichnet. Das Solarmodul 31 hingegen ist permanent an den Strang angeschaltet und speist Solarstrom in den Strang 20 ein, sofern Einstrahlung vorhanden ist. Dies hat den Vorteil, dass mit dem Strom des Solarmoduls 31 Prüf- und Anschaltprozesse in der Photovoltaik-Anlage 10 durchgeführt werden können und trotzdem keine berührgefährliche Spannung anliegt, bevor nicht die vorliegenden Prüfprozesse durchgeführt wurden und entsprechende Freigabebedingungen erfüllt sind. Daher wird das Solarmodul 31 auch als Start-Solarmodul 31 bezeichnet. Es können statt eines einzelnen Start-Solarmoduls 31 auch einige wenige Start-Solarmodule 31 vorgesehen sein, allerdings sollte die Gesamtspannung der Start-Solarmodule 31 unterhalb der Schwelle für berührgefährliche Spannung liegen. Im vorliegenden Beispiel hat das eine Start-Solarmodul 31 eine Nennspannung von 40V.

Die Startbox 70 umfasst eine Prüfschaltung bzw. Prüf- und Freigabeschaltung 71 mit einem Nebenschlussschalter 53 (S₃), mittels welchem der strangseitige Abschnitt 104 der Strangzuleitungen 102a, 102b kurzgeschlossen werden kann und einem seriellen Freischalter 54 (S₄) innerhalb einer der beiden Strangzuleitungen 102a, 102b, mittels welchem der wechselrichterseitige Abschnitt 106 vom strangseitigen Abschnitt 104 zumindest einseitig getrennt werden kann. Der Nebenschlussschalter 53 und der Freischalter 54 sind als FETs ausgebildet, wobei der Nebenschlussschalter 53 als Schließer und der Freischalter 54 als Öffner ausgebildet sind. Somit sind im Normalzustand der Nebenschlussschalter 53 geöffnet und der Freischalter 54 geschlossen.

Der Wechselrichter 90 besitzt eine gleichstromseitige Eingangskapazität 92 von z.B. 1 mF und eine DC-Trennvorrichtung 94, mittels welcher beide Pole des Wechselrichters 90 gleichstromseitig von den Strangzuleitungen 102a, 102b galvanisch getrennt werden können. Die DC-Trennvorrichtung 94 (Feuerwehr-Notschalter) kann z.B. in Form eines mechanischen Schalters oder in Form eines herausziehbaren Steckers ausgebildet sein. Eine Zielsetzung der vorliegenden Erfindung ist es, sicherzustellen, dass der der Wechselrichter 90 auch tatsächlich angeschaltet ist und der wechselrichterseitige Abschnitt 106 der Strangzuleitungen 102a, 102b geschlossen ist, wenn der Strang 20 vom gesicherten Zustand in den Betriebszustand versetzt werden soll. Der Wechselrichter 90 ist z.B. momentan tatsächlich nicht angeschaltet, wenn die DC-Trennvorrichtung 94 aktiviert (offen) ist oder wenn der Wechselrichter 90 überhaupt noch nicht montiert und angeschlossen wurde.

Die Eingangskapazität 92 wird im Normalzustand der Schalter 53, 54 in einem geladenen Zustand gehalten, wenn der Wechselrichter 90 angeschaltet ist, und zwar in dem Ausführungsbeispiel der Fig. 5 und 6 durch die Spannung des Start-Solarmoduls 31, sobald dieses eine hinreichende Einstrahlung erfährt. Somit befinden sich die Schalter 53, 54 in dem gesicherten Zustand vor dem Beginn des wechselrichterseitigen Prüfprozesses in demselben Zustand wie in dem Betriebszustand der Photovoltaik-Anlage 10., Mit anderen Worten befinden sich in vorteilhafter Weise der als Schließer ausgebildete Nebenschlussschalter 53 und/oder der als Öffner ausgebildete Freischalter 54 in dem gesicherten Zustand vor dem Beginn des wechselrichterseitigen Prüfprozesses und in dem Betriebszustand der Photovoltaik-Anlage 10 im Normalzustand.

Wenn der Strang 20 vom gesicherten Zustand in den Betriebszustand versetzt werden soll, wird, gesteuert durch den Controller oder Mikrocontroller 80 der Prüfschaltung 71, zunächst der wechselrichterseitige Prüfprozess durchgeführt. In dem wechselrichterseitigen Prüfprozess öffnet der Mikrocontroller 80 den Freischalter 54 und schließt den Nebenschlussschalter 53. Durch das Öffnen des Freischalters 54 wird die Eingangskapazität 92 nicht mehr länger geladen, so diese durch Verlust z.B. an einem internen Widerstand 96 parallel zu der Eingangskapazität 92 entlädt. Die Prüfschaltung 71 misst nun mittels eines wechselrichterseitigen Spannungssensors 74 den Spannungsabfall an den wechselrichterseitigen Ausgängen 73a, 73b der Startbox 70. Das Schließen des Nebenschlussschalters 53 verhindert eine Beeinträchtigung der Messung des Spannungsabfalls aufgrund einer zum Freischalter 54 parasitären Diode 56. Die Zeit für den Spannungsabfall ist ein Indikator für die Größe der angeschlossenen Kapazität 92. Ein typischer gemessener Spannungsverlauf mit angeschaltetem Wechselrichter ist in Fig. 9 mit dem Bezugszeichen 2 bezeichnet. Der Spannungsabfall erfolgt hierbei in der Größenordnung von etwa 45 ms. Die Kurve 1 zeigt den Spannungsabfall bei aktivierter DC-Trennvorrichtung 94, d.h. wenn der Wechselrichter 90 nicht angeschaltet ist, wobei der Spannungsabfall dann in wenigen ms erfolgt. Somit kann der wechselrichterseitige Prüfprozess in etwa 100 ms durchgeführt werden. Z.B. können hierzu zwei Spannungs-Messwerte, einer unmittelbar vor und einer zu einer vorbestimmten Zeit nach dem Öffnen des Freischalters 53, z.B. 5 ms nach dem Öffnen, verglichen werden, oder es wird der Verlauf des Spannungsabfalls nach dem Öffnen analysiert. In Ansprechen auf das Messergebnis bestimmt der Mikrocontroller 80 der Prüfschaltung 71 schließlich, ob der Wechselrichter 90 angeschaltet ist und ob der wechselrichterseitige Abschnitt 106 der Strangzuleitungen 102a, 102b geschlossen ist oder nicht.

Weitere Prüf- und insbesondere Anschaltprozesse an dem Strang 20 werden von dem Mikrocontroller 80 der Prüfschaltung 71 erst dann initiiert, wenn die Bestimmung ergeben hat, dass der wechselrichterseitige Abschnitt 106 der Strangzuleitungen 102a, 102b geschlossen und der Wechselrichter 90 angeschaltet ist. Somit kann unter anderem sichergestellt werden, dass keine berührgefährliche Offenspannung an offenen Kabelenden der wechselrichterseitigen Strangzuleitungen 102a, 102b bei einem noch nicht montierten Wechselrichter 90 anliegt. Ferner kann ein Anschalten des Strangs 20 vom gesicherten Zustand in den Betriebszustand verhindert werden, wenn die DC-Trennvorrichtung 94 des Wechselrichters 90 aktiviert ist. Dadurch kann vermieden werden, dass an dem wechselrichterseitigen Abschnitt 106 der Strangzuleitungen 102a, 102b oder dem Wechselrichter 90 eine berührgefährliche Offenspannung entsteht.

Das Gehäuse 69 der Startbox 70, von welchem die Prüfschaltung 71 beherbergt wird, ist ein spannungssicheres Gehäuse, ggf. mit Steckverbindern , die für eine berührgefährliche Spannung, z.B. bis 1000 V, zugelassen sind, da an der der Prüfschaltung 71 in dem Gehäuse 69 im Betriebszustand die gesamte Spannung des Strangs 20 anliegt. Das Gate des Schalters 54 der Prüfschaltung 71 ist vorzugsweise galvanisch von der Strangsspannung getrennt, z.B. mittels einer galvanischen Vortrennung und eines Optokopplers (nicht dargestellt).

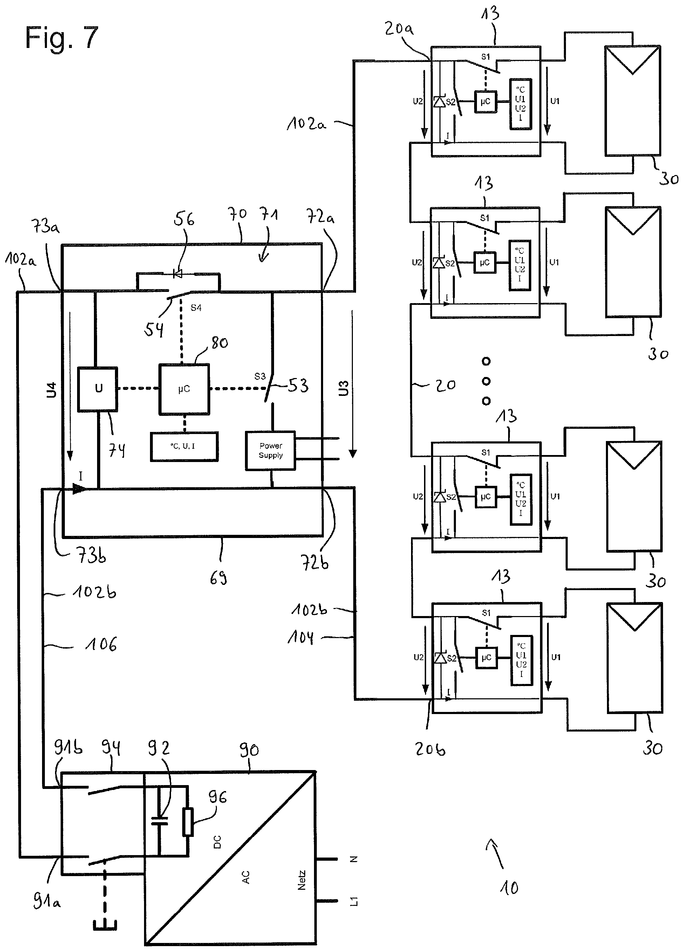

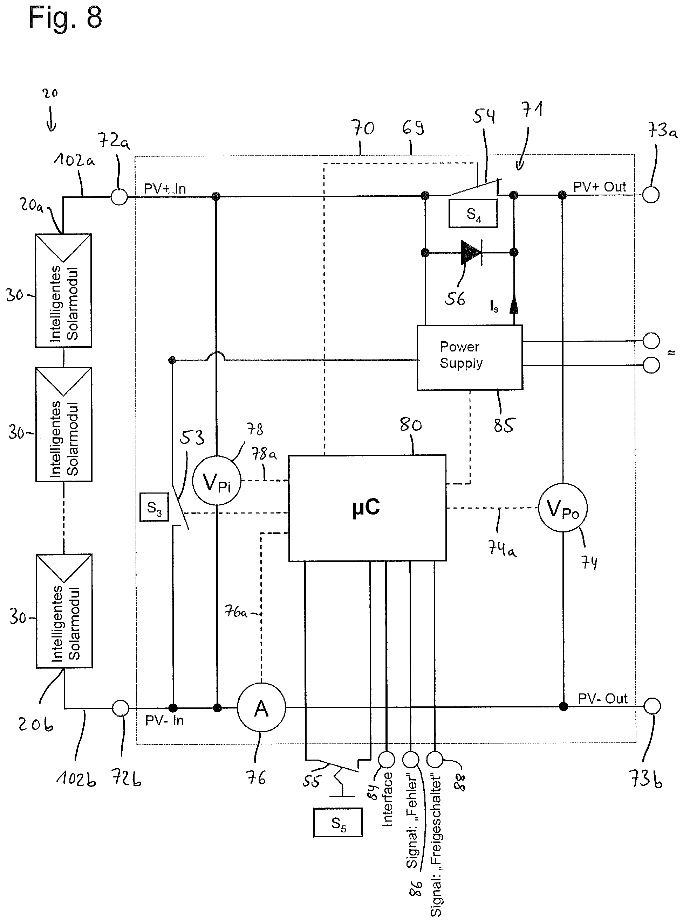

Bezug nehmend auf die Fig. 7 und 8 besteht der Strang 20 bei dieser Ausführungsform ausschließlich aus intelligenten Solarmodulen 30. In diesem Fall steht im gesicherten Zustand des Strangs 20 kein photovoltaisch erzeugter Strom zur Verfügung. Deshalb wird die Eingangskapazität 92 des Wechselrichters 90 von einem Netzteil der Startbox 70 in dem geladenen Zustand gehalten.

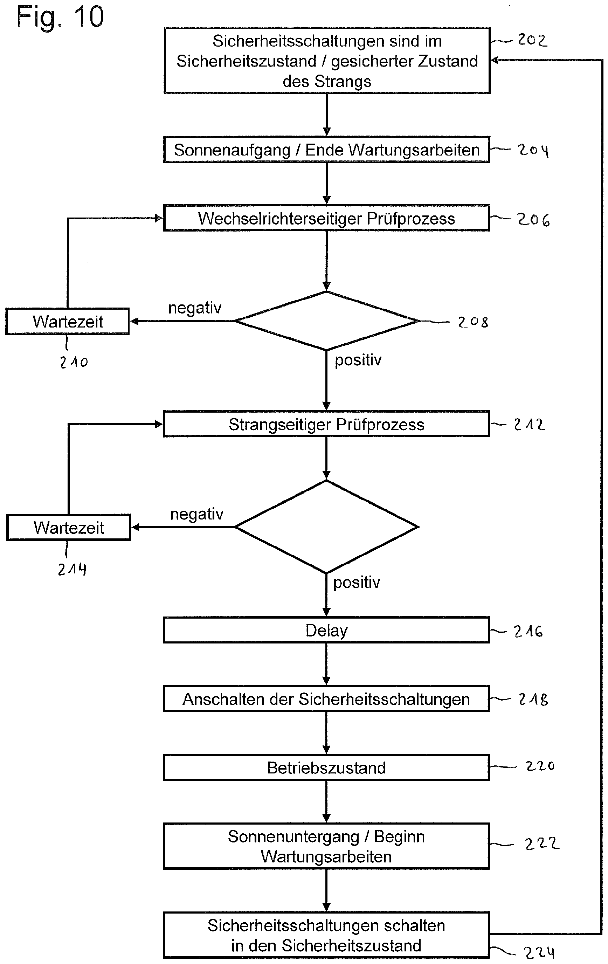

Bezug nehmend auf Fig. 10 wird ein Ausführungsbeispiel des Verfahrensablaufs bei Anschalten der Photovoltaik-Anlage vom gesicherten Zustand in den Betriebszustand wie folgt dargestellt.

In dem gesichertem Zustand 202 des Strangs 20 befinden sich alle Sicherheitsschaltungen 13 der intelligenten Solarmodule 30 in dem Sicherheitszustand.

Wenn zu einem Zeitpunkt 204 die Sonne aufgeht oder Wartungsarbeiten beendet sind, führt die Prüfschaltung 71 den wechselrichterseitigen Prüfprozess 206 durch. Wenn in dem Schritt 208 das Ergebnis der Bestimmung, ob der wechselrichterseitigen Abschnitt 106 der Strangzuleitungen 102a, 102b geschlossen und der Wechselrichter 90 angeschaltet ist, negativ ausfällt, wird nach einer Wartezeit 210 von z.B. 30 s, der wechselrichterseitige Prüfprozess 206 wiederholt, solange bis das Ergebnis in dem Schritt 208 positiv ist. Wenn in dem Schritt 208 das Ergebnis der Bestimmung ist, dass eine wechselrichterseitige Unterbrechung vorliegt, wird also der Strang 20 nicht in den Betriebszustand versetzt, sondern es wird nach einer vorbestimmten Wartezeit 210 der wechselrichterseitige Prüfprozess 206 wiederholt, so lange bis das Ergebnis positiv ist.

Wenn das Ergebnis positiv ist, wird ein strangseitiger Prüfprozess 212 durchgeführt, bei welchem geprüft wird, ob der strangseitige Abschnitt 104 der Strangzuleitungen 102a, 102b geschlossen ist. Bei negativem Ergebnis wird auch der strangseitige Prüfprozess 212 nach einer Wartezeit 214 wiederholt, solange bis das Ergebnis positiv ist.

Wenn das Ergebnis positiv ist, gibt die Prüfschaltung 71 das Anschalten der Sicherheitsschaltungen 13 frei und schaltet nach einem Delay 216 in einem Schritt 218 die Sicherheitsschaltungen 13 der intelligenten Solarmodule 30 an, d.h. vom Sicherheitszustand in den Betriebszustand 220, in welchem der Strang 20 dann Photovoltaik-Leistung in den Wechselrichter 90 einspeist.

In einem Schritt 224, schalten die Sicherheitsschaltungen 13 automatisch in den Sicherheitszustand, z.B. wenn zu einem Zeitpunkt 222 die Sonne untergeht, oder der Sicherzustand wird zum Zeitpunkt 222 manuell initiiert, z.B. wenn eine Wartung durchgeführt werden soll.

Im Folgenden wird noch ein Beispiel für den strangseitigen Prüf- und Anschaltprozess 212 - 218 erläutert.

Ein Spannungssensor 78 (V_{Pi}) misst die strangseitige Spannung U3. Ein Stromsensor 76 (A) misst den Strom über den Strang, welcher entweder der photovoltaisch erzeugte Solarstrom im Betriebszustand oder der Startstrom in dem gesicherten Zustand sein kann. Der Mikrocontroller 80 ist über Verbindungen 74a, 76a, 78a mit dem wechselrichterseitigen Spannungssensor 74 (V_{Po}), dem Stromsensor 76 bzw. dem strangseitigen Spannungssensor 78 verbunden und liest diese aus, um die Strangspannung U3, den Strom auf dem Strang und den Spannungsabfall U4 am wechselrichterseitigen Ausgang 73a, 73b zu messen und in Ansprechen auf einen oder mehrere dieser Messwerte die Prüfschaltung 71 in der Startbox 70 zu steuern.

In dem in Fig. 6 und 8 dargestellten Betriebszustand der Photovoltaik-Anlage 10 ist der Freischalter 54 geschlossen und der Nebenschlussschalter 53 ist geöffnet, so dass die dargestellte Prüfschaltung 71 in diesem Zustand nahezu verlustfrei ist und der photovoltaisch erzeugte Strom nahezu verlustfrei durch die Prüfschaltung 71 zum Wechselrichter 90 fließen kann.

Zum Starten der intelligenten Solarmodule 30 wird der Freischalter 54 geöffnet und der Nebenschlussschalter 53 geschlossen. Nun wird ein Startstrom l_{S} für eine vorbestimmte Zeit t_{S} in den Strang 20 eingeprägt. Die Photovoltaik-Anlage 10, das heißt die Solarmodule 30 befinden sich hierbei zunächst noch im Sicherheitszustand, so dass einerseits der in den Strang 20 eingeprägte Startstrom durch den Strang fließen kann und andererseits im Beispiel der Fig. 6 maximal der photovoltaisch erzeugte Strom des Start-Solarmoduls 31 durch den Strang 20 fließt.

In dem gesicherten Zustand des Strangs 20 ist also - sofern kein Störfall vorliegt - trotz Einzelfreischaltung der Solarmodule 30 der Stromkreis des Strangs 20 und des strangseitigen Abschnitts 104 der Strangzuleitungen 102a, 102b geschlossen. Mittels des eingeprägten Startstroms l_{S} wird ein Stromfluss durch den Strang 20 und den strangseitigen Abschnitt 104 der Strangzuleitungen 102a, 102b initiiert, welcher von den Stromsensoren 68 gemessen oder detektiert wird. In Ansprechen auf dieses Mess- oder Detektionsergebnis schalten dann die Sicherheitsschaltungen 13 automatisch vom Sicherheitszustand in den Betriebszustand um.

Wenn in Ansprechen hierauf alle intelligenten Solarmodule 30 aktiviert wurden, d.h. vom Sicherheitszustand in den Betriebszustand umgeschaltet haben, wird der Nebenschlussschalter 53 wieder geöffnet und der Freischalter 54 wird wieder geschlossen, so dass nun der photovoltaisch erzeugte Strom durch den Strang 20, die Strangzuleitungen 102a, 102b und die Prüfschaltung 71 bzw. die Startbox 70 bis zum Wechselrichter 90 fließen und die entsprechende Photovoltaik-Leistung ins Netz eingespeist werden kann.

Mit einem manuellen Aktivierungsschalter 55 (S5) können die Prüf- und Anschaltprozesse an der Startbox 70 auch manuell initiiert werden, d.h. die Photovoltaik-Anlage 10 manuell gestartet und der Strang 20 vom gesicherten Zustand in den Betriebszustand versetzt werden. Über eine elektronische Schnittstelle 84 des Mikrocontrollers 80 können diese Informationen zum Beispiel mit einem Computer ausgelesen werden. Der Mikrocontroller 80 weist ferner Signaleinrichtungen 86, 88 auf, zum Beispiel in Form von Leuchtdioden, welche an der Startbox 70 einen möglichen Fehlerzustand ("Fehler") bzw. das Vorliegen des Sicherheitszustandes ("Freigeschaltet") anzeigen.

Die Prüf- und/oder Anschaltprozesse können ferner über die Schnittstelle 84 ("Interface") durch eine übergeordnete Steuerung initiiert werden oder der digitale Eingang, an dem der Aktivierungsschalter 55 angeschlossen ist, kann über eine übergeordnete Steuerung geschaltet werden.

Im täglichen Normalbetrieb, wird bei Sonnenaufgang der wechselrichterseitige Prüfprozess 206, der strangseitige Prüfprozess 212 sowie der Anschaltschritt 218 von der Prüfschaltung 71 durchgeführt, damit der Ertrag der Anlage gesichert ist. Dies kann z.B. durch festgelegte Zeitpunkte in Ansprechen auf eine Zeitsteuerung oder durch Auslesen eines Einstrahlungssensors der Startbox 70 initiiert werden.

Nach Sonnenaufgang werden einerseits die Mikrocontroller 40 der Sicherheitsschaltungen 13 von den zugehörigen Solarmodulen 30 mit Energie versorgt, so dass diese auch in dem zunächst noch vorliegenden Sicherheitszustand energetisch in die Lage versetzt sind, die Sicherheitsschaltungen 13 zu steuern und vom Sicherheitszustand in den Betriebszustand umzuschalten.

Zum Starten prägt die Prüfschaltung 71 bei bereits geöffnetem oder durch Öffnen des Freischalters 54 und durch Schließen des Nebenschlussschalters 53 aus der Stromquelle 82 den Startstrom l_{S} in den Strang 20 ein, welcher von den noch im Sicherheitszustand befindlichen Sicherheitsschaltungen 13 mittels des Stromsensors 68 detektiert wird und in Ansprechen hierauf steuert der Mikrocontroller 40 die Sicherheitsschaltung 13 vom Sicherheitszustand in den Betriebszustand, in diesem Beispiel durch Schließen des Freischalters 51 und Öffnen des Kurzschlussschalters 52.

In vorteilhafter Weise ist so sicher gestellt, dass das Initiieren des Anschaltprozesses der intelligenten Solarmodule 30 nur gelingt, wenn die Strangzuleitungen 102a, 102b von der Startbox 70 gesehen sowohl wechselrichterseitig als auch strangseitig geschlossen und der Wechselrichter 90 tatsächlich angeschaltet ist, so dass an keiner Stelle der Verkabelung zwischen den Solarmodulen 30, 31 und dem Wechselrichter 90 eine gefährliche Offenspannung entstehen kann.

Im Übrigen kann in Bezug auf die strangseitigen Prüf- und Anschaltprozesse auf die WO 2014/122325 verwiesen werden.

Es ist dem Fachmann ersichtlich, dass die vorstehend beschriebenen Ausführungsformen beispielhaft zu verstehen sind, und die Erfindung nicht auf diese beschränkt ist, sondern in vielfältiger Weise variiert werden kann, ohne den Schutzbereich der Ansprüche zu verlassen. Ferner ist ersichtlich, dass die Merkmale unabhängig davon, ob sie in der Beschreibung, den Ansprüchen, den Figuren oder anderweitig offenbart sind, auch einzeln wesentliche Bestandteile der Erfindung definieren, selbst wenn sie zusammen mit anderen Merkmalen gemeinsam beschrieben sind. Ferner beziehen sich die Merkmale, die in Zusammenhang mit der Photovoltaik-Anlage beschrieben sind, auch auf die Prüfschaltung und entsprechend auf das Prüfverfahren und vice versa.

## Patentansprüche

1. Photovoltaik-Anlage (10) mit zumindest einem Strang (20) aus seriell zusammengeschalteten Solarmodulen (30, 31) und einem Wechselrichter (90) zum Umrichten des von dem Strang (20) erzeugten Gleichstroms,
wobei im Normalzustand das positive Ende (20a) des Strangs(20) mit einer Pluspol-Strangzuleitung (102a) an den Pluspol-Gleichstromeingang (91a) des Wechselrichters (90) und das negative Ende (20b) des Strangs (20) mit einer Minuspol-Strangzuleitung (102b) an den Minuspol-Gleichstromeingang (91b) des Wechselrichters (90) angeschlossen sind,
wobei eine Prüfschaltung (71) umfasst ist, welche zwischen das positive Ende des Strangs (20a) und den Pluspol-Gleichstromeingang (91a) des Wechselrichters (90) in die Pluspol-Strangzuleitung (102a) und/oder zwischen das negative Ende (20b) des Strangs (20) und den Minuspol-Gleichstromeingang (91b) des Wechselrichters (90) in die Minuspol-Strangzuleitung (102B) geschaltet ist,
wobei die Prüfschaltung (71) zumindest einen ersten Schalter (54) zum Trennen der Pluspol-Strangzuleitung (102a) zwischen dem positiven Ende (20a) des Strangs (20) und dem Pluspol-Gleichstromeingang (91a) des Wechselrichters (90) oder zum Trennen der Minuspol-Strangzuleitung (102b) zwischen dem negativen Ende (20b) des Strangs (20) und dem Minuspol-Gleichstromeingang (91b) des Wechselrichters (90) aufweist,
**dadurch gekennzeichnet dass** der Wechselrichter (90) eine gleichstromseitige Kapazität (92) aufweist,
wobei die Prüfschaltung (71) in einem wechselrichterseitigen Prüfprozess (206), den ersten Schalter (54) öffnet, um die gleichstromseitige Kapazität (92) des Wechselrichters (90) zumindest einseitig von dem Strang (20) und/oder von einer Spannungsversorgung der Prüfschaltung (71) zu trennen, und wobei die Prüfschaltung (71) in Ansprechen auf den durch das Trennen der gleichstromseitigen Kapazität (92) des Wechselrichters ausgelösten Spannungsabfall (1, 2) bestimmt, ob der Wechselrichter (90) momentan tatsächlich an die Strangzuleitungen (102a, 102b) angeschaltet ist und/oder ob der wechselrichterseitige Abschnitt (106) der Strangzuleitungen (102a, 102b) geschlossen ist oder nicht.

2. Photovoltaik-Anlage (10) nach Anspruch 1, wobei die Prüfschaltung (71) Mittel umfasst, welche den Strang (20) in Ansprechen auf den Spannungsabfall aus einem gesicherten Zustand in einen Betriebszustand oder umgekehrt versetzen.

3. Photovoltaik-Anlage (10) nach Anspruch 1 oder 2, umfassend eine Trennvorrichtung (94) mittels welcher der wechselrichterseitige Abschnitt (106) der Strangzuleitungen (102a, 102b) trennbar ist.

4. Photovoltaik-Anlage (10) nach einem der vorstehenden Ansprüche, wobei
i) wenn das Ergebnis der Bestimmung des Spannungsabfalls in dem wechselrichterseitigen Prüfprozess (206) ergibt, dass der Wechselrichter (90) an die Strangzuleitungen (102a; 102b) angeschaltet ist und der wechselrichterseitige Abschnitt (106) der Strangzuleitungen geschlossen ist, die Prüfschaltung (71) weitere Prüf- und/oder Anschaltprozesse (212-218) in dem Strang auslöst, um den Strang (20) in den Betriebszustand zu versetzen und
ii) wenn das Ergebnis der Bestimmung des Spannungsabfalls ergibt, dass der Wechselrichter (90) nicht an die Strangzuleitungen (102a, 102b) angeschaltet ist oder der wechselrichterseitige Abschnitt (106) der Strangzuleitungen (102a, 102b) unterbrochen ist, die Prüfschaltung (71) den Strang (20) nicht in den Betriebszustand versetzt, der erste Schalter (54) wieder schließt und den wechselrichterseitigen Prüfprozess (206) nach einer vorbestimmten Zeit (210) wiederholt und zwar so oft, bis das Ergebnis der Bestimmung des Spannungsabfalls ergibt, dass der Wechselrichter (90) an die Strangzuleitungen angeschaltet ist und/oder der wechselrichterseitige Abschnitt (106) der Strangzuleitungen geschlossen ist.

5. Photovoltaik-Anlage (10) nach einem der vorstehenden Ansprüche, wobei die Prüfschaltung (71) den Spannungsabfall durch einen Vergleich der Spannungen vor und nach dem Öffnen des ersten Schalters (54) und/oder durch eine Spannungsverlaufsmessung nach dem Öffnen des ersten Schalters (54) bestimmt.

6. Photovoltaik-Anlage (10) nach einem der vorstehenden Ansprüche, wobei die Prüfschaltung (71) entfernt von den Solarmodulen (30, 31) in die Pluspol-Strangzuleitung (102a) und/oder die Minuspol-Strangzuleitung (102b) geschaltet ist.

7. Photovoltaik-Anlage (10) nach einem der vorstehenden Ansprüche, wobei die Prüfschaltung (71) von einer Startbox (70) beherbergt wird und die Startbox (70) zwischen das positive Ende (20a) des Strangs (20) und den Pluspol-Gleichstromeingang (91a) des Wechselrichters (90) in die Pluspol-Strangzuleitung (102a) und zwischen das negative Ende (20b) des Strangs (20) und den Minuspol-Gleichstromeingang (91 b) des Wechselrichters (90) in die Minuspol-Strangzuleitung (102b) geschaltet ist, so dass die Pluspol-Strangzuleitung (102a) und die Minuspol-Strangzuleitung (102a) elektrisch durch die Startbox (70) geleitet werden.

8. Photovoltaik-Anlage (10) nach Anspruch 7, wobei
die Startbox (70) entfernt von den Solarmodulen (30, 31) in die Pluspol-Strangzuleitung (102a) und/oder die Minuspol-Strangzuleitung (102b) geschaltet ist, so dass die Pluspol-Strangzuleitung (102a) von einem strangseitigen Abschnitt (104), welcher sich von dem positiven Ende (20a) des Strangs (20) bis zu der Startbox (70) erstreckt und einem wechselrichterseitigen Abschnitt (106), welcher sich von der Startbox (70) bis zu dem Pluspol-Gieichrichtereingang (91a) erstreckt und/oder die Minuspol-Strangzuleitung (102b) von einem strangseitigen Abschnitt (104), welcher sich von dem negativen Ende (20b) des Strangs (20) bis zu der Startbox (70) erstreckt und einem wechselrichterseitigen Abschnitt (106), welcher sich von der Startbox (70) bis zu dem Minuspol-Gleichrichtereingang (91b) erstreckt, gebildet werden.

9. Photovoltaik-Anlage (10) nach einem der vorstehenden Ansprüche, wobei die Prüfschaltung (71) einen strangseitig des ersten Schalters (54) angeordneten zweiten Schalter (53) umfasst, welcher die erste und zweite Strangzuleitung (102a, 102b) strangseitig des ersten Schalters (54) kurzschließt, wenn in dem wechselrichterseitigen Prüfprozess (206) der Spannungsabfall an der gleichstromseitigen Kapazität (92) des Wechselrichters (90) bestimmt wird.

10. Photovoltaik-Anlage (10) nach einem der vorstehenden Ansprüche, wobei der erste und/oder zweite Schalter (54, 53) als Halbleiterschaltelemente ausgebildet sind.

11. Photovoltaik-Anlage (10) nach einem der vorstehenden Ansprüche, wobei der erste Schalter (54) als Öffner ausgebildet ist, der im Normalzustand geschlossen ist und/oder der zweite Schalter (53) als Schließer ausgebildet ist, der im Normalzustand geöffnet ist.

12. Photovoltaik-Anlage (10) nach einem der vorstehenden Ansprüche, wobei die Solarmodule (30, 31) jeweils eine Solaranschlussdose (12) umfassen, mittels welchen die Anschlusselemente des zugehörigen Solarmoduls (30, 31) kontaktiert sind, und wobei zumindest einige der Solarmodule (30) eine Sicherheitsschaltung (13) aufweisen, welche einen Betriebszustand und einen Sicherheitszustand definieren, wobei das jeweilige Solarmodul (30) in dem Betriebszustand Solarstrom in die Strangzuleitungen (102a, 102b) einspeist und in dem Sicherheitszustand keinen Solarstrom in die Strangzuleitungen (102a, 102b) einspeist.

13. Photovoltaik-Anlage (10) nach Anspruch 12, wobei
der Strang (20) eine Mehrzahl von Solarmodulen (30) mit der Sicherheitsschaltung (13) und zumindest ein Start-Solarmodul (31) aufweist, welches auch dann Solarstrom in die Strangzuleitungen (102a, 102b) einspeist, wenn die Solarmodule (30) mit der Sicherheitsschaltung (13) im Sicherheitszustand sind.

14. Photovoltaik-Anlage (10) nach Anspruch 12 oder 13, wobei wenn das Ergebnis der Bestimmung des Spannungsabfalls in dem wechselrichterseitigen Prüfprozess (206) ergibt, dass der Wechselrichter (90) an die Strangzuleitungen (102a, 102b) angeschaltet ist und der wechselrichterseitige Abschnitt (106) der Strangzuleitungen (102a, 102b) geschlossen ist, die Prüfschaltung (71) einen strangseitigen Prüfprozess (212) auslöst, welcher prüft, ob der von der Prüfschaltung (71) aus gesehen strangseitige Stromkreis der Strangzuleitungen (102a, 102b) geschlossen ist und bei positivem Prüfergebnis die Sicherheitsschaltungen (13) der Solarmodule (30) in den Betriebszustand versetzt, so dass der Strang (20) elektrische Leistung an den Wechselrichter (90) liefert.

15. Photovoltaik-Anlage (10) nach einem der Ansprüche 12-14, wobei die gleichstromseitige Kapazität (92) des Wechselrichters (90) vor dem wechselrichterseitigen Prüfprozess (206) von dem oder den Start-Solarmodulen (31) oder von einer Spannungsversorgung der Prüfschaltung (71) geladen wird, um die Ladung der gleichstromseitigen Kapazität (92) des Wechselrichters (90) für den wechselrichterseitigen Prüfprozess (206) zum Zeitpunkt des Öffnens des ersten Schalters (53) zu gewährleisten.

16. Prüfschaltung (71), insbesondere gemäß einem der vorstehenden Ansprüche, zur Durchführung eines wechselrichterseitigen Prüfprozesses (206) in einer Photovoltaik-Anlage (10) mit zumindest einem Strang (20) aus seriell zusammengeschalteten Solarmodulen (30, 31) und einem Wechselrichter (90) zum Umrichten des von dem Strang (20) erzeugten Gleichstroms, wobei im Normalzustand das positive Ende (20a) des Strangs (20) mit einer Pluspol-Strangzuleitung (102a) an den Pluspol-Gleichstromeingang (91a) des Wechselrichters (90) und das negative Ende (20b) des Strangs (20) mit einer Minuspol-Strangzuleitung (102b) an den Minuspol-Gleichstromeingang (91b) des Wechselrichters (90) angeschlossen sind,
wobei die Prüfschaltung (71) zwischen das positive Ende (20a) des Strangs (20) und den Pluspol-Gleichstromeingang (91a) des Wechselrichters (90) in die Pluspol-Strangzuleitung (102a) und/oder zwischen das negative Ende (20b) des Strangs (20) und den Minuspol-Gleichstromeingang (91b) des Wechselrichters (90) in die Minuspol-Strangzuleitung (102b) anschließbar ist,
wobei die Prüfschaltung (71) zumindest einen ersten Schalter (54) zum Trennen der Pluspol-Strangzuleitung (102a) zwischen dem positiven Ende (20a) des Strangs (20) und dem Pluspol-Gleichstromeingang (91a) des Wechselrichters (90) oder zum Trennen der Minuspol-Strangzuleitung (102b) zwischen dem negativen Ende (20b) des Strangs (20) und dem Minuspol-Gleichstromeingang (91b) des Wechselrichters (90) aufweist,
wobei die Prüfschaltung (71) in einem wechselrichterseitigen Prüfprozess (206) den ersten Schalter (54) öffnet, um eine gleichstromseitige Kapazität (92) des Wechselrichters (90) zumindest einseitig von dem Strang (20) und/oder von einer Spannungsversorgung der Prüfschaltung (71) zu trennen, und wobei die Prüfschaltung (71) in Ansprechen auf den durch das Trennen der gleichstromseitigen Kapazität (92) des Wechselrichters (90) ausgelösten Spannungsabfall bestimmt, ob der Wechselrichter (90) momentan tatsächlich an die Strangzuleitungen (102a, 102b) angeschaltet ist und/oder ob der wechselrichterseitige Abschnitt (106) der Strangzuleitungen (102a, 102b) geschlossen ist oder nicht.

17. Prüfverfahren für eine Photovoltaik-Anlage, gemäß einem der Ansprüche 1-15, mit zumindest einem Strang (20) aus seriell zusammengeschalteten Solarmodulen (30, 31) und einem im Normalzustand an die Strangzuleitungen (102a, 102b) angeschlossenen Wechselrichter (90) zum Umrichten des von dem Strang (20) erzeugten Gleichstroms,
wobei in einem gesicherten Zustand (202) des Strangs (20), in welchem zumindest einige der Solarmodule (30) des Strangs (20) abgeschaltet sind, derart dass der Strang (20) in dem gesicherten Zustand keine berührgefährliche Spannung an die Strangzuleitungen (102a, 102b) anlegt, folgende Schritte durchgeführt werden:
a) Vor einem wechselrichterseitigen Prüfprozess (206) Aufrechterhalten der Ladung einer gleichstromseitigen Kapazität (92) des Wechselrichters (90) mit einer gegenüber der Strangspannung reduzierten Startspannung, und nachfolgend
b) Durchführen des wechselrichterseitigen Prüfprozesses (206), bei welchem die gleichstromseitige Kapazität (92) des Wechselrichters (90) zumindest einseitig von der Startspannung getrennt wird, und
c) in Ansprechen auf den durch das Trennen der gleichstromseitigen Kapazität des Wechselrichters ausgelösten Spannungsabfall (1, 2), Bestimmen, ob der Wechselrichter (90) momentan tatsächlich an die Strangzuleitungen (102a, 102b) angeschaltet ist und/oder ob der wechselrichterseitige Abschnitt (106) der Strangzuleitungen (102a, 102b) geschlossen ist oder nicht.

## Claims

1. A photovoltaic system (10), comprising at least one string (20) of series-connected solar modules (30, 31) and an inverter (90) for converting the direct current generated by the string (20);
wherein in the normal state, the positive end (20a) of the string (20) is connected, via a positive pole string line (102a), to the positive pole DC input (91a) of the inverter (90), and the negative end (20b) of the string (20) is connected, via a negative pole string line (102b), to the negative pole DC input (91 b) of the inverter (90);
wherein a test circuit (71) is comprised, which is connected in the positive pole string line (102a) between the positive end of the string (20a) and the positive pole DC input (91a) of the inverter (90), and/or in the negative pole string line (102b) between the negative end (20b) of the string (20) and the negative pole DC input (91b) of the inverter (90);
wherein the test circuit (71) includes at least a first switch (54) for disconnecting the positive pole string line (102a) between the positive end (20a) of the string (20) and the positive pole DC input (91a) of the inverter (90), or for disconnecting the negative pole string line (102b) between the negative end (20b) of the string (20) and the negative pole DC input (91b) of the inverter (90);
**characterised in that**
the inverter (90) includes a DC-side capacitor (92);
wherein, in an inverter-side testing process (206), the test circuit (71) opens the first switch (54) so as to disconnect the DC-side capacitor (92) of the inverter (90) from the string (20) and/or from a voltage supply of the test circuit (71), at least at one side; and wherein the test circuit (71) is responsive to a voltage drop (1, 2) caused by the disconnection of the DC-side capacitor (92) of the inverter to determine whether the inverter (90) is actually connected to the string lines (102a, 102b) at that moment and/or whether the inverter-side section (106) of the string lines (102a, 102b) is closed or not.

2. The photovoltaic system (10) according to claim 1, wherein the test circuit (71) comprises means which are responsive to the voltage drop to switch the string (20) from a protective state into an operating state, or vice versa.

3. The photovoltaic system (10) according to claim 1 or 2, comprising an isolation device (94) by means of which the inverter-side section (106) of the string lines (102a, 102b) can be disconnected.

4. The photovoltaic system (10) according to any one of the preceding claims, wherein
i) if the result of the determination of the voltage drop in the inverter-side testing process (206) indicates that the inverter (90) is connected to the string lines (102a, 102b) and that the inverter-side section (106) of the string lines is closed, the test circuit (71) initiates further testing and/or start-up processes (212 - 218) in the string to put the string (20) into the operating state; and
ii) if the result of the determination of the voltage drop indicates that the inverter (90) is not connected to the string lines (102a, 102b) or that the inverter-side section (106) of the string lines (102a, 102b) is interrupted, the test circuit (71) does not put the string (20) into the operating state, the first switch (54) is closed again, and the inverter-side testing process (206) is repeated after a predetermined time (210) until the result of the determination of the voltage drop indicates that the inverter (90) is connected to the string lines and/or that the inverter-side section (106) of the string lines is closed.

5. The photovoltaic system (10) according to any one of the preceding claims, wherein the test circuit (71) determines the voltage drop by comparing the voltages before and after opening the first switch (54), and/or by a voltage waveform measurement after opening the first switch (54).

6. The photovoltaic system (10) according to any one of the preceding claims, wherein the test circuit (71) is connected in the positive pole string line (102a) and/or in the negative pole string line (102b) remote from the solar modules (30, 31).

7. The photovoltaic system (10) according to any one of the preceding claims, wherein the test circuit (71) is accommodated in a start box (70), and wherein the start box (70) is connected in the positive pole string line (102a) between the positive end (20a) of the string (20) and the positive pole DC input (91a) of the inverter (90) and in the negative pole string line (102b) between the negative end (20b) of the string (20) and the negative pole DC input (91b) of the inverter (90), so that the positive pole string line (102a) and the negative pole string line (102a) are electrically routed through the start box (70).

8. The photovoltaic system (10) according to claim 7, wherein the start box (70) is connected in the positive pole string line (102a) and/or in the negative pole string line (102b) remote from the solar modules (30, 31), so that the positive pole string line (102a) is formed by a string-side section (104) extending from the positive end (20a) of the string (20) to the start box (70) and an inverter-side section (106) extending from the start box (70) to the positive pole inverter input (91a), and/or the negative pole string line (102b) is formed by a string-side section (104) extending from the negative end (20b) of the string (20) to the start box (70) and an inverter-side section (106) extending from the start box (70) to the negative pole inverter input (91b).

9. The photovoltaic system (10) according to any one of the preceding claims, wherein the test circuit (71) comprises a second switch (53) arranged on the string side of the first switch (54), for short-circuiting the first and second string lines (102a, 102b) on the string side of the first switch (54) when the inverter-side testing process (206) determines the voltage drop across the DC-side capacitor (92) of the inverter (90).

10. The photovoltaic system (10) according to any one of the preceding claims, wherein the first and/or second switches (54, 53) are implemented as semiconductor switching elements.

11. The photovoltaic system (10) according to any one of the preceding claims, wherein the first switch (54) is configured as a break contact switch which is closed in its normal state, and/or the second switch (53) is configured as a make contact switch which is open in its normal state.

12. The photovoltaic system (10) according to any one of the preceding claims, wherein the solar modules (30, 31) each comprise a solar junction box (12) through which the connection elements of the associated solar module (30, 31) are electrically connected, and wherein at least some of the solar modules (30) include a safety circuit (13) which defines an operating state and a safe state, wherein in the operating state the respective solar module (30) feeds solar power to the string lines (102a, 102b) and in the safe state it does not feed solar power to the string lines (102a, 102b).

13. The photovoltaic system (10) according to claim 12, wherein the string (20) comprises a plurality of solar modules (30) which include the safety circuit (13), and at least one start-up solar module (31) which feeds solar power into the string lines (102a, 102b) even when the solar modules (30) that include the safety circuit (13) are in the safe state.

14. The photovoltaic system (10) according to claim 12 or 13, wherein, if the result of the determination of the voltage drop in the inverter-side testing process (206) indicates that the inverter (90) is connected to the string lines (102a, 102b) and that the inverter-side section (106) of the string lines (102a, 102b) is closed, the test circuit (71) initiates a string-side testing process (212) which checks whether the circuit of the string lines (102a, 102b) on the string-side of the test circuit (71) is closed, and if the test result is positive, puts the safety circuits (13) of the solar modules (30) into the operating state, so that the string (20) provides electrical power to the inverter (90).

15. The photovoltaic system (10) according to any one of claims 12 to 14, wherein the DC-side capacitor (92) of the inverter (90) is charged prior to the inverter-side testing process (206) by the one or more start-up solar module(s) (31) or by a power supply of the test circuit (71), in order to ensure a charged state of the DC-side capacitor (92) of the inverter (90) at the time the first switch (53) is opened for the inverter-side testing process (206).

16. A test circuit (71) according to any one of the preceding claims, for performing an inverter-side testing process (206) in a photovoltaic system (10) which comprises at least one string (20) of series-connected solar modules (30, 31) and an inverter (90) for converting the direct current generated by the string (20), wherein in the normal state the positive end (20a) of the string (20) is connected, via a positive pole string line (102a), to the positive pole DC input (91a) of the inverter (90), and the negative end (20b) of the string (20) is connected, via a negative pole string line (102b), to the negative pole DC input (91b) of the inverter (90);
wherein the test circuit (71) is connectable into the positive pole string line (102a) between the positive end of the string (20a) and the positive pole DC input (91a) of the inverter (90), and/or into the negative pole string line (102b) between the negative end (20b) of the string (20) and the negative pole DC input (91b) of the inverter (90);
wherein the test circuit (71) includes at least a first switch (54) for disconnecting the positive pole string line (102a) between the positive end (20a) of the string (20) and the positive pole DC input (91a) of the inverter (90), or for disconnecting the negative pole string line (102b) between the negative end (20b) of the string (20) and the negative pole DC input (91b) of the inverter (90);
wherein, in an inverter-side testing process (206), the test circuit (71) opens the first switch (54) so as to disconnect a DC-side capacitor (92) of the inverter (90) from the string (20) and/or from a voltage supply of the test circuit (71) at least at one side, and wherein in response to the voltage drop (1, 2) caused by the disconnection of the DC-side capacitor (92) of the inverter, the test circuit (71) determines whether the inverter (90) is actually connected to the string lines (102a, 102b) at that moment and/or whether the inverter-side section (106) of the string lines (102a, 102b) is closed or not.

17. A testing method for a photovoltaic system according to any one of claims 1 to 15, which comprises at least one string (20) of series-connected solar modules (30,31) and an inverter (90) that is connected to the string lines (102a, 102b) in the normal state, for converting the direct current generated by the string (20);
wherein in a protective state (202) of the string (20), in which at least some of the solar modules (30) of the string (20) are disconnected such that the string (20) does not apply any hazardous contact voltage to the string lines (102a, 102b) in the protective state, the following steps are performed:
a) prior to an inverter-side testing process (206), maintaining a DC-side capacitor (92) of the inverter (90) in a charged state by a starting voltage which is reduced compared to the string voltage; and subsequently
b) performing the inverter-side testing process (206), in which the DC-side capacitor (92) of the inverter (90) is disconnected from the starting voltage at least on one side; and
c) in response to a voltage drop (1,2) caused by the disconnection of the DC-side capacitor of the inverter, determining whether the inverter (90) is actually connected to the string lines (102a, 102b) at that moment and/or whether the inverter-side section (106) of the string lines (102a, 102b) is closed or not.

## Revendications

1. Installation photovoltaïque (10) comprenant au moins une branche (20), constituée de modules solaires (30, 31) interconnectés en série, et un onduleur (90) destiné à convertir le courant continu produit par la branche (20),
sachant qu'à l'état normal, l'extrémité positive (20a) de la branche (20) est raccordée par une ligne d'arrivée de branche de pôle positif (102a) à l'entrée de courant continu de pôle positif (91a) de l'onduleur (90), et l'extrémité négative (20b) de la branche (20) est raccordée par une ligne d'arrivée de branche de pôle négatif (102b) à l'entrée de courant continu de pôle négatif (91b) de l'onduleur (90),
sachant qu'il est prévu un circuit de contrôle (71) qui est intercalé dans la ligne d'arrivée de branche de pôle positif (102a), entre l'extrémité positive de la branche (20a) et l'entrée de courant continu de pôle positif (91a) de l'onduleur (90) et/ou est intercalé dans la ligne d'arrivée de branche de pôle négatif (102B), entre l'extrémité négative (20b) de la branche (20) et l'entrée de courant continu de pôle négatif (91b) de l'onduleur (90),
sachant que le circuit de contrôle (71) présente au moins un premier interrupteur (54) destiné à sectionner la ligne d'arrivée de branche de pôle positif (102a), entre l'extrémité positive (20a) de la branche (20) et l'entrée de courant continu de pôle positif (91a) de l'onduleur (90), ou à sectionner la ligne d'arrivée de branche de pôle négatif (102b), entre l'extrémité négative (20b) de la branche (20) et l'entrée de courant continu de pôle négatif (91b) de l'onduleur (90),
**caractérisé en ce que**
l'onduleur (90) présente une capacité côté courant continu (92),
le circuit de contrôle (71) ouvrant, au cours d'un processus de contrôle côté onduleur (206), le premier interrupteur (54) pour séparer la capacité côté courant continu (92) de l'onduleur (90) au moins sur un côté de la branche (20) et/ou d'une alimentation en tension du circuit de contrôle (71), et le circuit de contrôle (71) déterminant, en réponse à la chute de tension (1, 2) déclenchée par la séparation de la capacité côté courant continu (92) de l'onduleur, si l'onduleur (90) est momentanément réellement raccordé aux lignes d'arrivée de branche (102a, 102b) et/ou si la portion côté onduleur (106) des lignes d'arrivée de branche (102a, 102b) est fermée ou non.

2. Système photovoltaïque (10) selon la revendication 1, dans lequel le circuit de contrôle (71) comprend des moyens qui font passer la branche (20) d'un état sécurisé à un état de fonctionnement, ou inversement, en réponse à la chute de tension.

3. Système photovoltaïque (10) selon la revendication 1 ou 2, comprenant un dispositif sectionneur (94) qui permet de séparer la portion côté onduleur (106) des lignes d'arrivée de branche (102a, 102b).

4. Système photovoltaïque (10) selon l'une des revendications précédentes, dans lequel
i) lorsque le résultat de la détermination de la chute de tension, au cours du processus de contrôle côté onduleur (206), indique que l'onduleur (90) est raccordé aux lignes d'arrivée de branche (102a, 102b) et que la portion côté onduleur (106) des lignes d'arrivée de branche est fermée, le circuit de contrôle (71) déclenche des processus de contrôle et/ou de raccordement(212-218) supplémentaires dans la branche, pour faire passer la branche (20) à l'état de fonctionnement, et
ii) lorsque le résultat de la détermination de la chute de tension indique que l'onduleur (90) n'est pas raccordé aux lignes d'arrivée de branche (102a, 102b) ou que la portion côté onduleur (106) des lignes d'arrivée de branche (102a, 102b) est interrompue, le circuit de contrôle (71) ne fait pas passer la branche (20) à l'état de fonctionnement, referme le premier interrupteur (54) et répète le processus de contrôle côté onduleur (206) après une durée prédéterminée (210), et cela autant de fois que nécessaire pour que le résultat de la détermination de la chute de tension indique que l'onduleur (90) est raccordé aux lignes d'arrivée de branche et/ou que la portion côté onduleur (106) des lignes d'arrivée de branche est fermée.

5. Système photovoltaïque (10) selon l'une des revendications précédentes, dans lequel le circuit de contrôle (71) détermine la chute de tension par une comparaison des tensions avant et après l'ouverture du premier interrupteur (54) et/ou par une mesure de la variation de tension après l'ouverture du premier interrupteur (54).

6. Système photovoltaïque (10) selon l'une des revendications précédentes, dans lequel le circuit de contrôle (71) est connecté à distance des modules solaires (30, 31) dans la ligne d'arrivée de branche de pôle positif (102a) et/ou la ligne d'arrivée de branche de pôle négatif (102b).

7. Système photovoltaïque (10) selon l'une des revendications précédentes, dans lequel le circuit de contrôle (71) est logé dans une boîte de démarrage (70), et la boîte de démarrage (70) est montée dans la ligne d'arrivée de branche de pôle positif (102a), entre l'extrémité positive (20a) de la branche (20) et l'entrée de courant continu de pôle positif (91a) de l'onduleur (90), et dans la ligne d'arrivée de branche de pôle négatif (102b), entre l'extrémité négative (20b) de la branche (20) et l'entrée de courant continu de pôle négatif (91b) de l'onduleur (90), de sorte que la ligne d'arrivée de branche de pôle positif (102a) et la ligne d'arrivée de branche de pôle négatif (102b) sont guidées électriquement à travers la boîte de démarrage (70).

8. Système photovoltaïque (10) selon la revendication 7, dans lequel la boîte de démarrage (70) est connectée à distance des modules solaires (30, 31) dans la ligne d'arrivée de branche de pôle positif (102a) et/ou la ligne d'arrivée de branche de pôle négatif (102b), de sorte que la ligne d'arrivée de branche de pôle positif (102a) est formée d'une portion côté branche (104), qui s'étend depuis l'extrémité positive (20a) de la branche (20) jusqu'à la boîte de démarrage (70), et d'une portion côté onduleur (106), qui s'étend depuis la boîte de démarrage (70) jusqu'à l'entrée de courant continu de pôle positif (91a), et/ou la ligne d'arrivée de branche de pôle négatif (102b) est formée d'une portion côté branche (104), qui s'étend depuis l'extrémité négative (20b) de la branche (20) jusqu'à la boîte de démarrage (70), et d'une portion côté onduleur (106) qui s'étend depuis la boîte de démarrage (70) jusqu'à l'entrée de courant continu de pôle négatif (91b).

9. Système photovoltaïque (10) selon l'une des revendications précédentes, dans lequel le circuit de contrôle (71) comprend un deuxième interrupteur (53) qui est disposé côté branche du premier interrupteur (54) et qui met en court-circuit la première et la deuxième ligne d'arrivée de branche (102a, 102b), côté branche du premier interrupteur (54), lorsque, au cours du processus de contrôle côté onduleur (206), la chute de tension sur la capacité côté courant continu (92) de l'onduleur (90) est déterminée.

10. Système photovoltaïque (10) selon l'une des revendications précédentes, dans lequel le premier et/ou le deuxième interrupteur (54, 53) sont réalisés sous forme d'éléments de commutation à semiconducteur.

11. Système photovoltaïque (10) selon l'une des revendications précédentes, dans lequel le premier interrupteur (54) est réalisé comme contact à ouverture, qui est fermé à l'état normal, et/ou le deuxième interrupteur (53) est réalisé comme contact à fermeture qui est ouvert à l'état normal.

12. Système photovoltaïque (10) selon l'une des revendications précédentes, dans lequel les modules solaires (30, 31) comportent respectivement une boîte de jonction solaire (12), par l'intermédiaire desquelles les éléments de raccordement du module solaire (30, 31) associé sont connectés, et dans lequel au moins certains des modules solaires (30) présentent un circuit de sécurité (13) qui définit un état de fonctionnement et un état de sécurité, sachant qu'à l'état de fonctionnement, le module solaire (30) respectif injecte du courant solaire dans les lignes d'arrivée de branche (102a, 102b) et, à l'état de sécurité, n'injecte pas de courant solaire dans les lignes d'arrivée de branche (102a, 102b).

13. Système photovoltaïque (10) selon la revendication 12, dans lequel la branche (20) présente une pluralité de modules solaires (30) dotés du circuit de sécurité (13) et au moins un module solaire de démarrage (31) qui injecte du courant solaire dans les lignes d'arrivée de branche (102a, 102b) même lorsque les modules solaires (30) dotés du circuit de sécurité (13) sont à l'état de sécurité.

14. Système photovoltaïque (10) selon la revendication 12 ou 13, dans lequel, lorsque le résultat de la détermination de la chute de tension, au cours du processus de contrôle côté onduleur (206), indique que l'onduleur (90) est raccordé aux lignes d'arrivée de branche (102a, 102b) et que la portion côté onduleur (106) des lignes d'arrivée de branche (102a, 102b) est fermée, le circuit de contrôle (71) déclenche un processus de contrôle côté branche (212) qui vérifie si le circuit électrique des lignes d'arrivée de branche (102a, 102b), situé côté branche, vu depuis le circuit de contrôle (71), est raccordé et, si le résultat du contrôle est positif, fait passer les circuits de sécurité (13) des modules solaires (30) à l'état de fonctionnement, de sorte que la branche (20) fournit de la puissance électrique à l'onduleur (90).

15. Système photovoltaïque (10) selon l'une des revendications 12 à 14, dans lequel la capacité côté courant continu (92) de l'onduleur (90) est chargée par le ou les modules solaires de démarrage (31) ou par une alimentation en tension du circuit de contrôle (71), avant le processus de contrôle côté onduleur (206), afin de garantir la charge de la capacité côté courant continu (92) de l'onduleur (90) pour le processus de contrôle côté onduleur (206), à l'instant de l'ouverture du premier interrupteur (53).

16. Circuit de contrôle (71) selon l'une des revendications précédentes, destiné à la mise en oeuvre d'un processus de contrôle côté onduleur (206) dans un système photovoltaïque (10) comprenant au moins une branche (20), constituée de modules solaires (30, 31) montés en série, et un onduleur (90) destiné à convertir le courant continu produit par la branche (20), sachant qu'à l'état normal, l'extrémité positive (20a) de la branche (20) est raccordée par une ligne d'arrivée de branche de pôle positif (102a) à l'entrée de courant continu de pôle positif (91a) de l'onduleur (90), et l'extrémité négative (20b) de la branche (20) est raccordée par une ligne d'arrivée de branche de pôle négatif (102b) à l'entrée de courant continu de pôle négatif (91b) de l'onduleur (90),
sachant que le circuit de contrôle (71) peut être intercalé dans la ligne d'arrivée de branche de pôle positif (102a), entre l'extrémité positive (20a) de la branche (20) et l'entrée de courant continu de pôle positif (91a) de l'onduleur (90) et/ou dans la ligne d'arrivée de branche de pôle négatif (102b), entre l'extrémité négative (20b) de la branche (20) et l'entrée de courant continu de pôle négatif (91b) de l'onduleur (90),
sachant que le circuit de contrôle (71) présente au moins un premier interrupteur (54) destiné à sectionner la ligne d'arrivée de branche de pôle positif (102a), entre l'extrémité positive (20a) de la branche (20) et l'entrée de courant continu de pôle positif (91a) de l'onduleur (90), ou à sectionner la ligne d'arrivée de branche de pôle négatif (102a), entre l'extrémité négative (20b) de la branche (20) et l'entrée de courant continu de pôle négatif (91b) de l'onduleur (90),
le circuit de contrôle (71) ouvrant, au cours d'un processus de contrôle côté onduleur (206), le premier interrupteur (54) pour séparer une capacité côté courant continu (92) de l'onduleur (90) au moins sur un côté de la branche (20) et/ou d'une alimentation en tension du circuit de contrôle (71), et le circuit de contrôle (71) déterminant, en réponse à la chute de tension déclenchée par la séparation de la capacité côté courant continu (92) de l'onduleur (90), si l'onduleur (90) est momentanément réellement raccordé aux lignes d'arrivée de branche (102a, 102b) et/ou si la portion côté onduleur (106) des lignes d'arrivée de branche (102a, 102b) est fermée ou non,

17. Procédé de contrôle pour un système photovoltaïque selon l'une des revendications 1 à 15, comprenant au moins une branche (20), constituée de modules solaires (30, 31) montés en série, et un onduleur (90) qui, à l'état normal, est raccordé aux lignes d'arrivée de branche (102a, 102b) et est destiné à convertir le courant continu produit par la branche (20),
sachant que dans un état de sécurité (202) de la branche (20) dans lequel au moins certains des modules solaires (30) de la branche (20) sont coupés, de sorte qu'à l'état de sécurité la branche (20) n'applique pas de tension dangereuse en cas de contact aux lignes d'arrivée de branche (102a, 102b), les étapes suivantes sont exécutées :
a) avant un processus de contrôle côté onduleur (206), maintien de la charge d'une capacité côté courant continu (92) de l'onduleur (90), avec une tension de démarrage réduite par rapport à la tension de branche, et ensuite
b) mise en oeuvre du processus de contrôle côté onduleur (206), lors duquel la capacité côté courant continu (92) de l'onduleur (90) est séparée au moins sur un côté de la tension de démarrage, et
c) en réponse à la chute de tension (1, 2) déclenchée par la séparation de la capacité côté courant continu (92) de l'onduleur, détermination pour savoir si l'onduleur (90) est momentanément réellement raccordé aux lignes d'arrivée de branche (102a, 102b) et/ou si la portion côté onduleur (106) des lignes d'arrivée de branche (102a, 102b) est fermée ou non.
